# EUROPEAN PATENT APPLICATION

(11) **EP 4 057 352 A1**
(43) Date of publication of application: **14.09.2022**
(21) Application number: 20885356.4
(22) Date of filing: 21.07.2020
(51) Int. Cl.: H01L 27/146, H04N 5/369

(54) **SOLID-STATE IMAGING ELEMENT AND IMAGING DEVICE**

(30) Priority: 08.11.2019 JP 2019202857
(71) Applicant: Sony Semiconductor Solutions Corporation, Atsugi-shi Kanagawa 243-0014 (JP)
(72) Inventor: HASEGAWA, Daisuke, Atsugi-shi, Kanagawa 243-0014 (JP)
(74) Representative: Müller Hoffmann & Partner
(86) International application number: PCT/JP2020/028244
(87) International publication number: WO 2021/090537

(57) **Abstract**

The present technique improves the quality of image data in a solid-state image sensor provided with a light control element.

The solid-state image sensor includes a pair of electrodes and the light control element. In the solid-state image sensor including the pair of electrodes and the light control element, the pair of electrodes are disposed along a predetermined arrangement direction perpendicular to an optical axis of incident light. Additionally, in the solid-state image sensor, the light control element is disposed between the pair of electrodes disposed along the predetermined arrangement direction perpendicular to the optical axis of the incident light, and transmits the incident light at a transmittance based on a voltage between the pair of electrodes.

## Description

### [Technical Field]

The present technique relates to a solid-state image sensor and an imaging device. In particular, the present technique relates to a solid-state image sensor that adjusts the light intensity of incident light, and to an imaging device.

### [Background Art]

Conventionally, light modulating elements, which are elements in which the transmittance changes in accordance with an applied voltage, have been used in solid-state image sensors for the purpose of adjusting the light intensity of incident light. For example, a solid-state image sensor has been proposed in which a top electrode, a light control element, and a bottom electrode are stacked in that order from the top, with an incidence direction of incident light as the upward direction (see, for example, PTL 1).

### [Citation List]

### [Patent Literature]

[PTL 1]
JP 2014-135452 A

### [Summary]

### [Technical Problem]

In the conventional technique described above, the incident light intensity is adjusted by applying a voltage between the top electrode and the bottom electrode to change the transmittance of the light control element. However, in the aforementioned solid-state image sensor, some of the incident light transmitted through the light control element is blocked by the wiring underneath the light control element, and the quality of the image data may drop due to the resulting vignetting.

Having been achieved in light of such circumstances, an object of the present technique is to improve the image quality of image data in a solid-state image sensor provided with a light control element.

### [Solution to Problem]

Having been achieved in order to solve the above-described problems, a first aspect of the present technique is a solid-state image sensor, including: a pair of electrodes disposed along a predetermined arrangement direction perpendicular to an optical axis of incident light; and a light control element that is disposed between the pair of electrodes and that transmits the incident light at a transmittance based on a voltage between the pair of electrodes. This provides an effect in that oblique incidence characteristics are improved.

Additionally, in the first aspect, the light control element may be an element having a plate shape. This provides an effect in that the plate-shaped light control element adjusts the transmitted light intensity.

Additionally, in the first aspect, the pair of electrodes and the light control element may be provided for each of a plurality of pixels, and the light control element may be disposed in a region covering part of a light-receiving region of a photodiode. This provides an effect in that a phase difference is detected.

Additionally, in the first aspect, the pair of electrodes and the light control element may be provided for a specific pixel among a plurality of pixels, and the light control element may be disposed in a region covering part of a light-receiving region of a photodiode. This provides an effect in that the sensitivity of pixels in which the light control element is not provided is improved.

Additionally, in the first aspect, the solid-state image sensor may further include a control line and a ground line; the pair of electrodes and the light control element may be provided for each of a plurality of pixels; and the pair of electrodes provided for a specific pixel among the plurality of pixels may be connected to the control line and the ground line. This provides an effect in that a phase difference is detected.

Additionally, in the first aspect, a plurality of slits extending in a specific direction may be formed in the light control element; each of the pair of electrodes may include a linear connection part extending in a direction perpendicular to the arrangement direction and the optical axis and a protruding part protruding along the specific direction; and the protruding part may be disposed in a corresponding one of the slits. This provides an effect in that the power consumption is reduced.

Additionally, in the first aspect, the pair of electrodes may be transparent. This provides an effect in that the electrodes transmit incident light.

Additionally, in the first aspect, the pair of electrodes may be opaque. This provides an effect in that polarization characteristics are controlled.

Additionally, in the first aspect, the solid-state image sensor may further include a wiring layer and a photoelectric conversion element that receives the incident light, and the wiring layer may be disposed between the light control element and the photoelectric conversion element. This provides an effect in that the front surface of a semiconductor substrate is irradiated with the incident light.

Additionally, in the first aspect, the solid-state image sensor may further include a wiring layer and a photoelectric conversion element that receives the incident light, and the photoelectric conversion element may be disposed between the light control element and the wiring layer. This provides an effect in that the back surface of a semiconductor substrate is irradiated with the incident light.

A second aspect of the present technique is an imaging device including: a pair of electrodes disposed along a predetermined arrangement direction perpendicular to an optical axis of incident light; a light control element that is disposed between the pair of electrodes and that transmits the incident light at a transmittance based on a voltage between the pair of electrodes; and a signal processing circuit that processes a pixel signal according to an intensity of the incident light. This provides an effect in that pixel signals from pixels having improved oblique incidence characteristics are processed.

### [Brief Description of Drawings]

[Fig. 1]

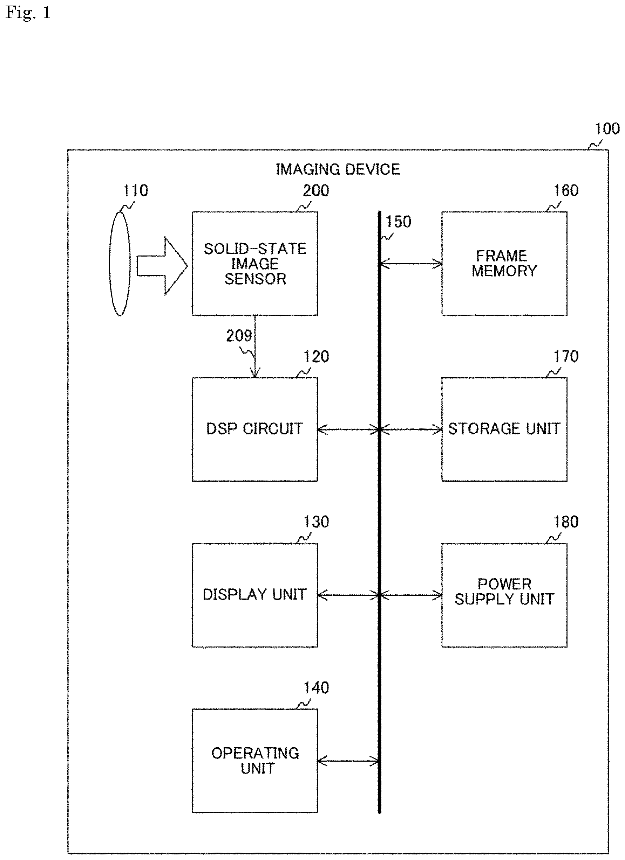

   Fig. 1 is a block diagram illustrating an example of the configuration of an imaging device according to a first embodiment of the present technique.
[Fig. 2]

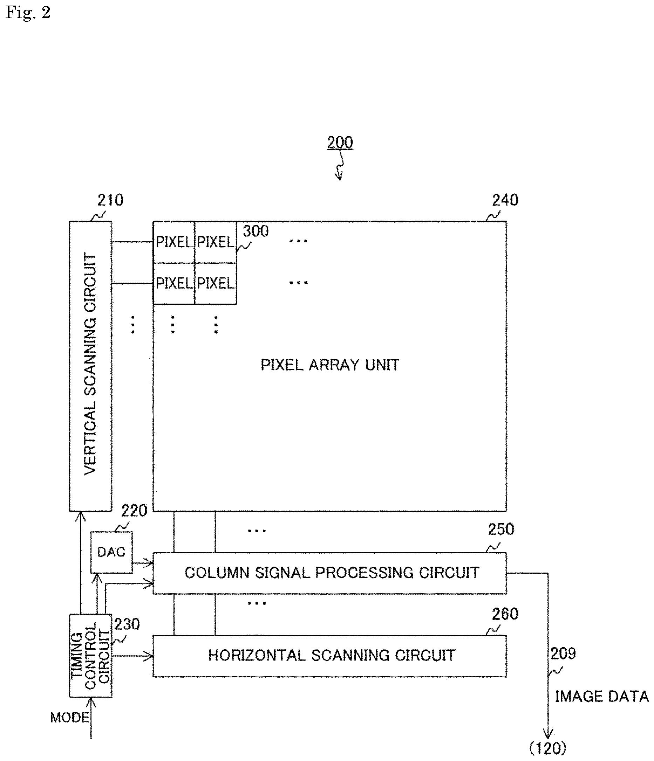

   Fig. 2 is a block diagram illustrating an example of the configuration of a solid-state image sensor according to the first embodiment of the present technique.
[Fig. 3]

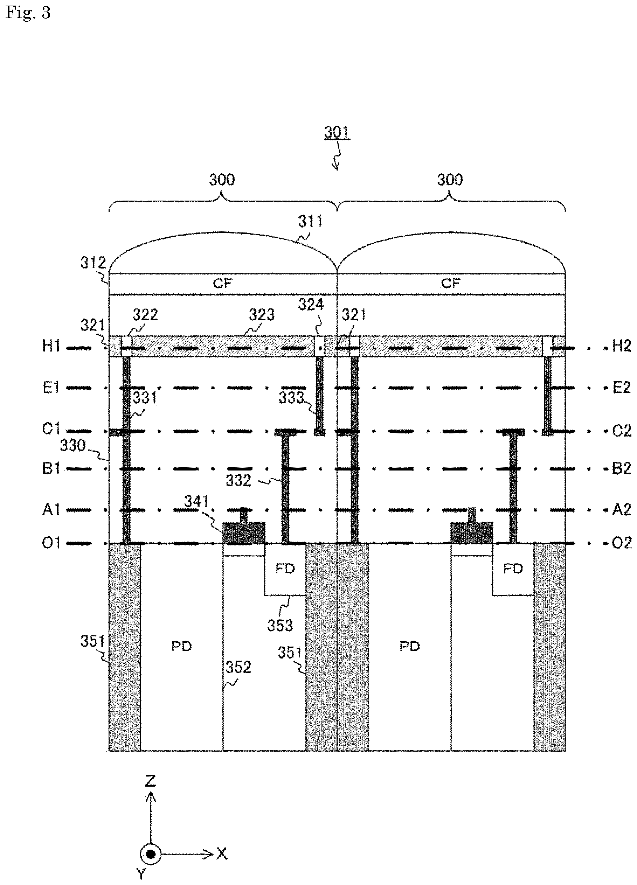

   Fig. 3 is an example of a cross-sectional view of a pixel according to the first embodiment of the present technique.
[Fig. 4]

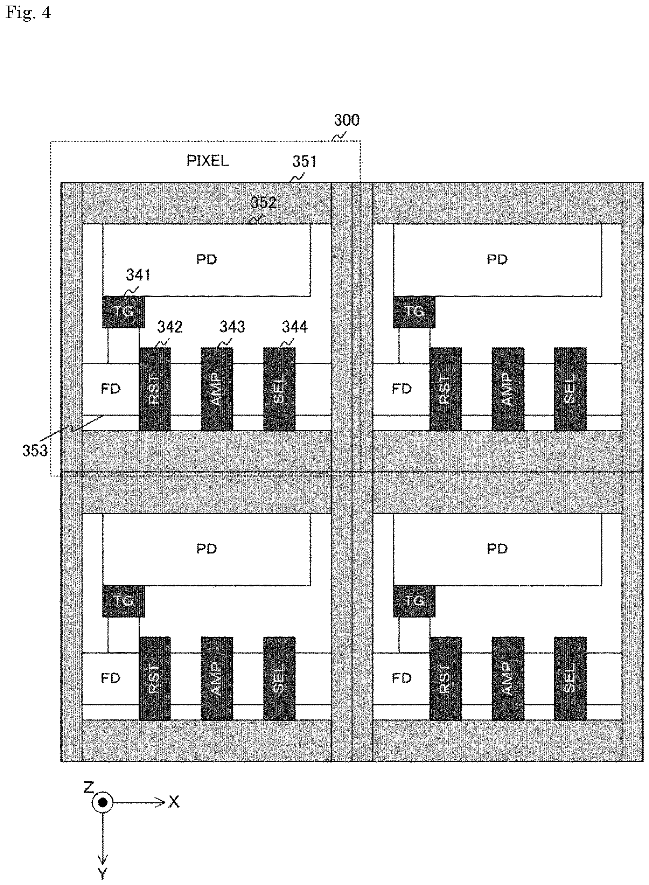

   Fig. 4 is a plan view illustrating an example of the layout of photodiodes and transistors according to the first embodiment of the present technique.
[Fig. 5]

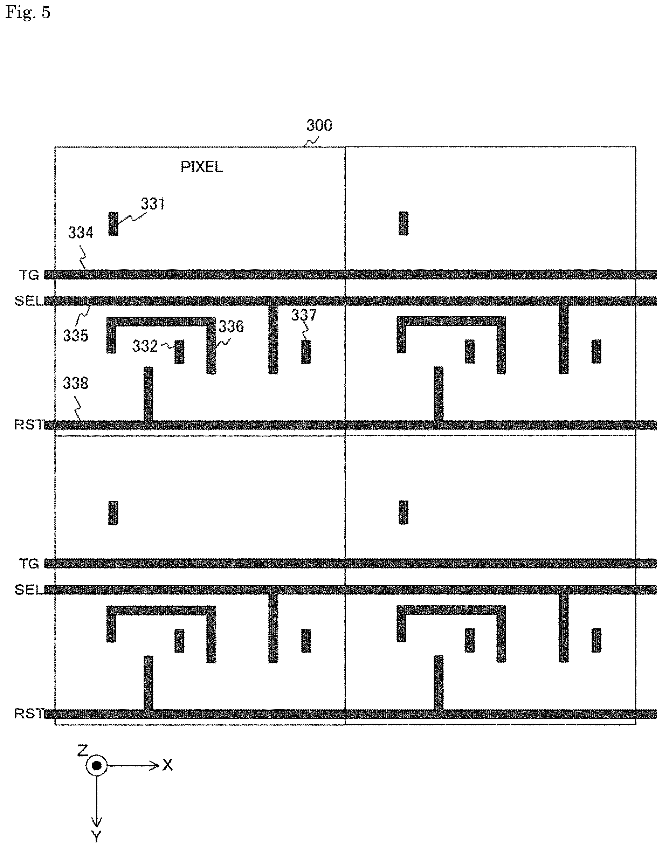

   Fig. 5 is a plan view illustrating an example of the wiring layout of signal lines in a row direction according to the first embodiment of the present technique.
[Fig. 6]

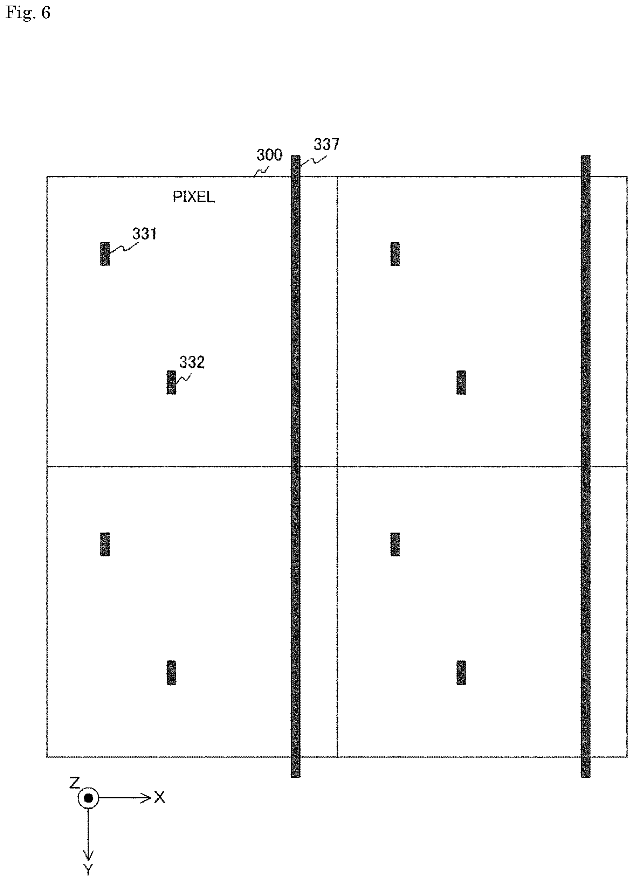

   Fig. 6 is a plan view illustrating an example of the wiring layout of signal lines in a column direction according to the first embodiment of the present technique.
[Fig. 7]

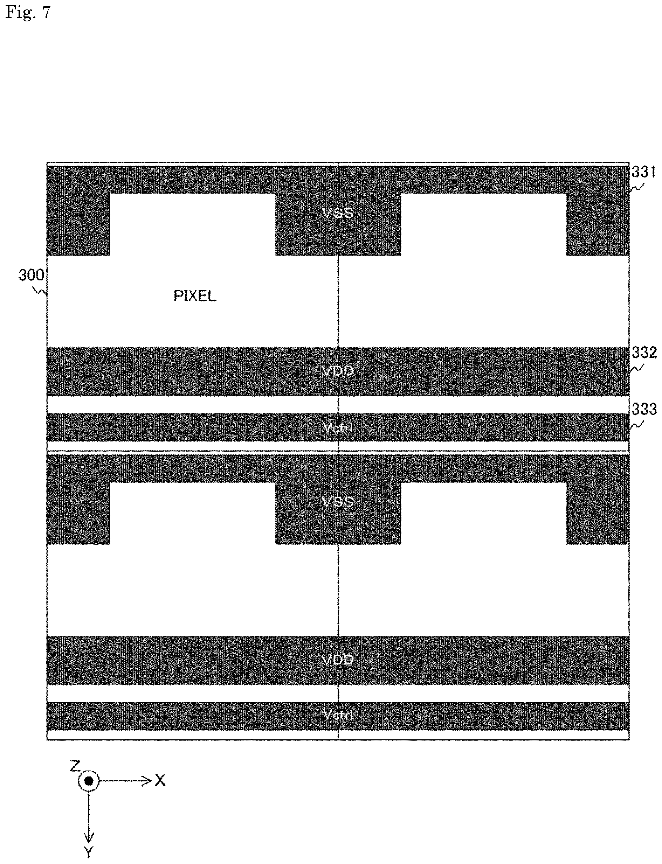

   Fig. 7 is a plan view illustrating an example of the wiring layout of power lines, ground lines, and control lines according to the first embodiment of the present technique.
[Fig. 8]

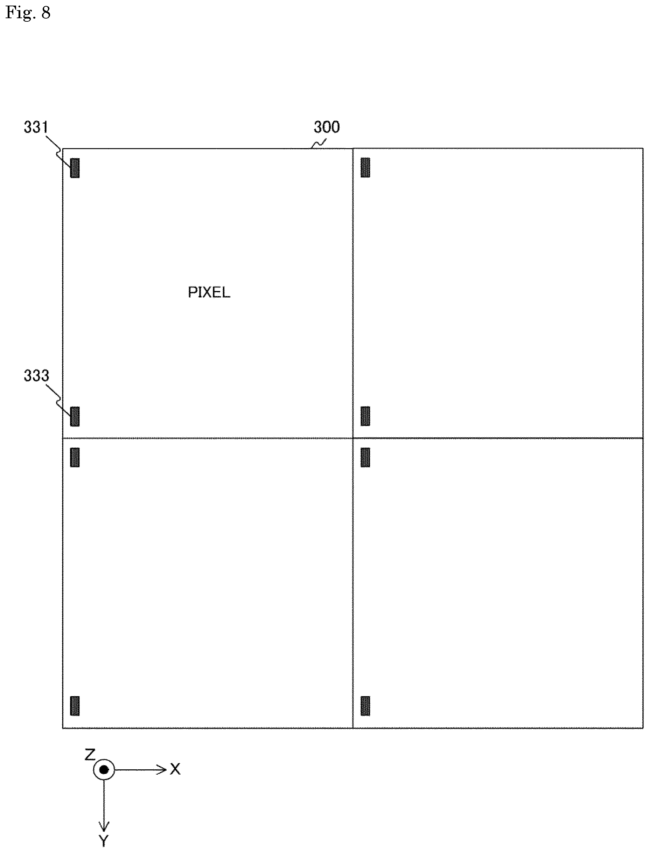

   Fig. 8 is a plan view illustrating an example of the arrangement of contacts of ground lines and control lines according to the first embodiment of the present technique.
[Fig. 9]

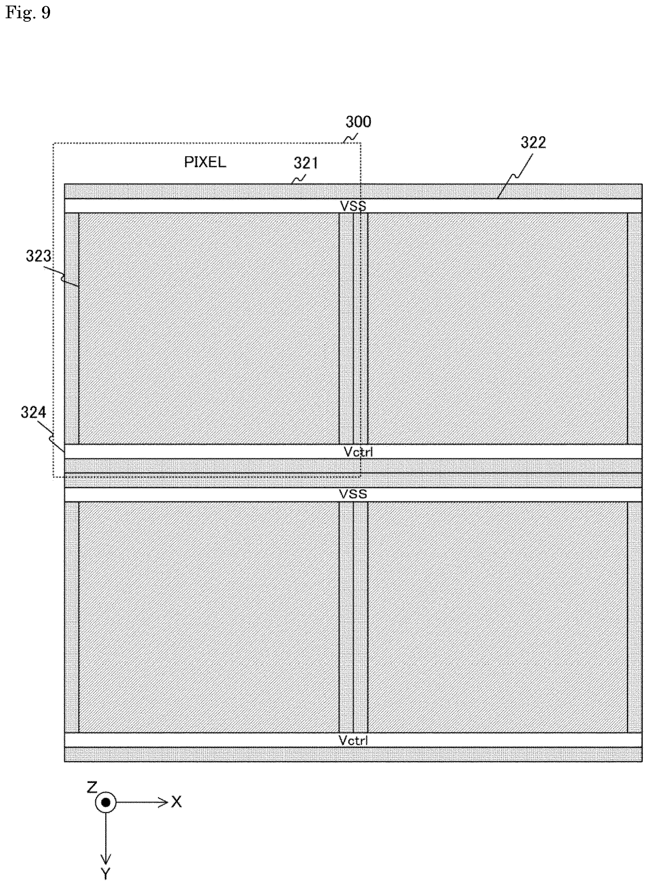

   Fig. 9 is a plan view illustrating an example of the layout of transparent electrodes and light modulating elements according to the first embodiment of the present technique.
[Fig. 10]

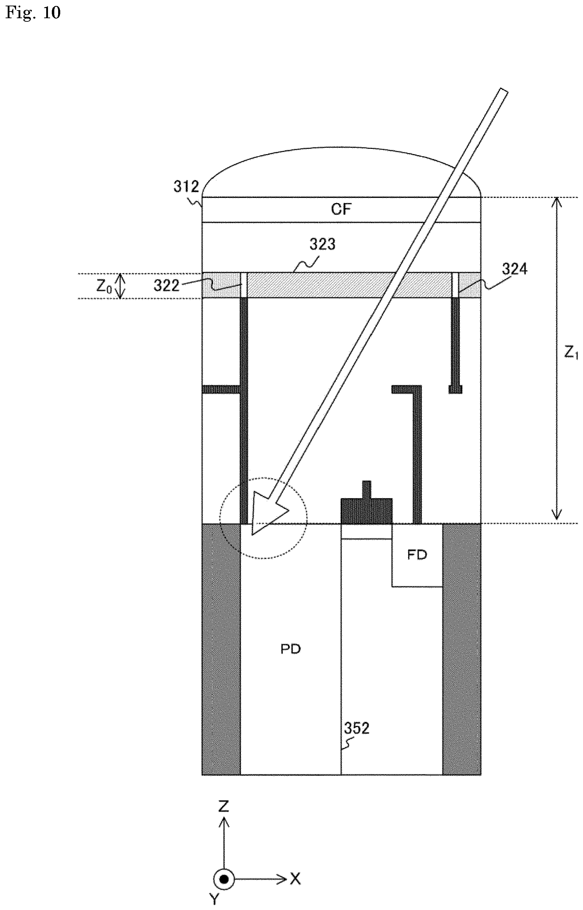

   Fig. 10 is a diagram illustrating an example of the trajectory of incident light when a control voltage is low according to the first embodiment of the present technique.
[Fig. 11]

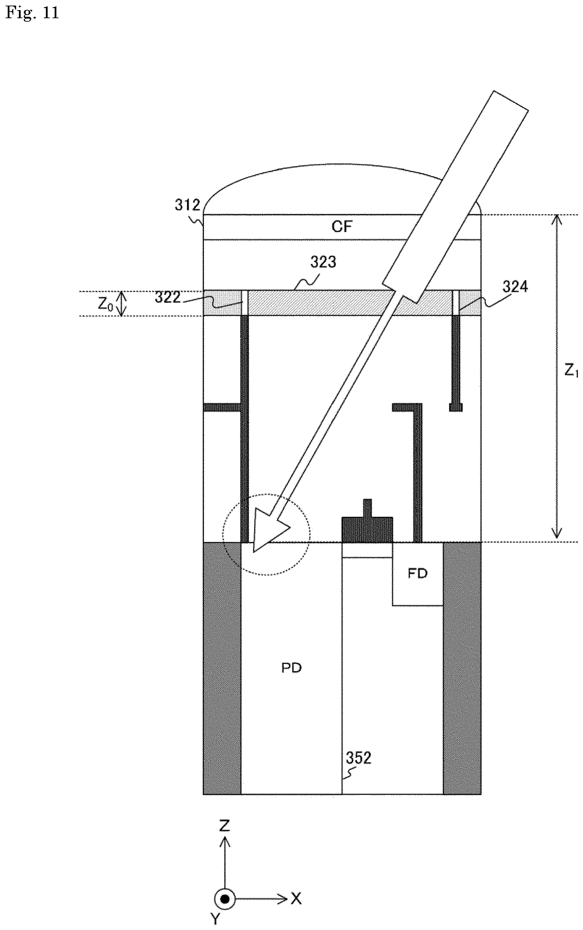

   Fig. 11 is a diagram illustrating an example of the trajectory of incident light when the control voltage is high according to the first embodiment of the present technique.
[Fig. 12]

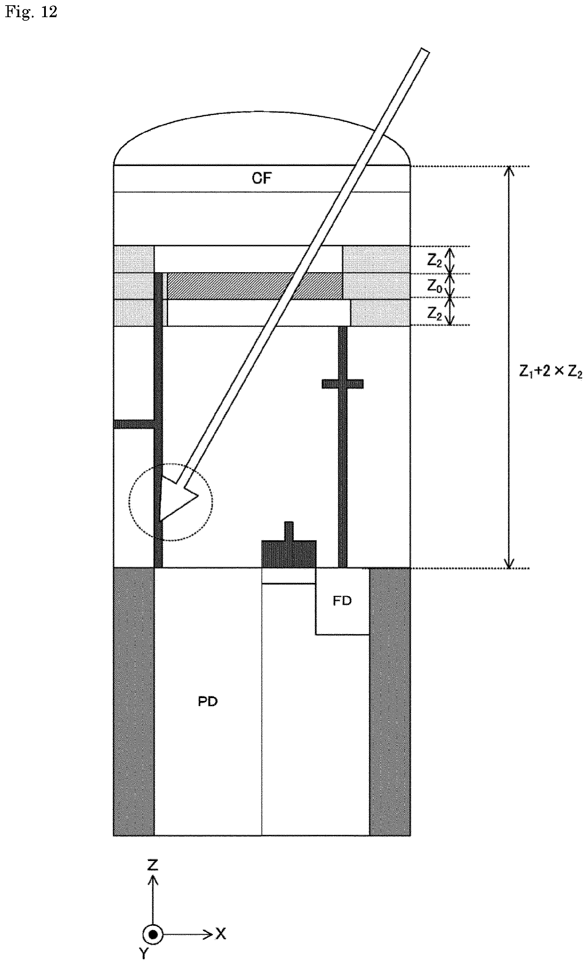

   Fig. 12 is a diagram illustrating an example of the trajectory of incident light when the control voltage is high according to a comparative example.
[Fig. 13]

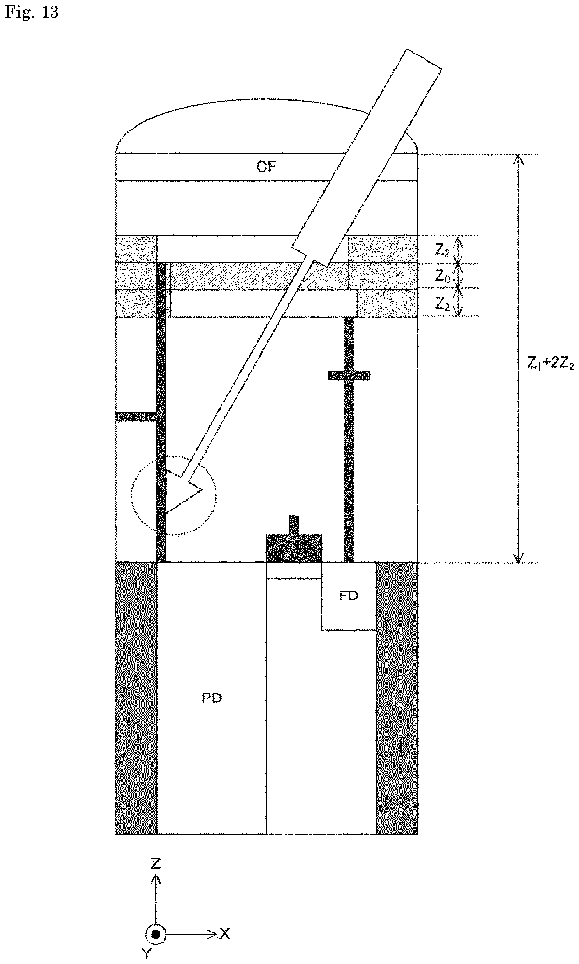

   Fig. 13 is a diagram illustrating an example of the trajectory of incident light when the control voltage is low according to the comparative example.
[Fig. 14]

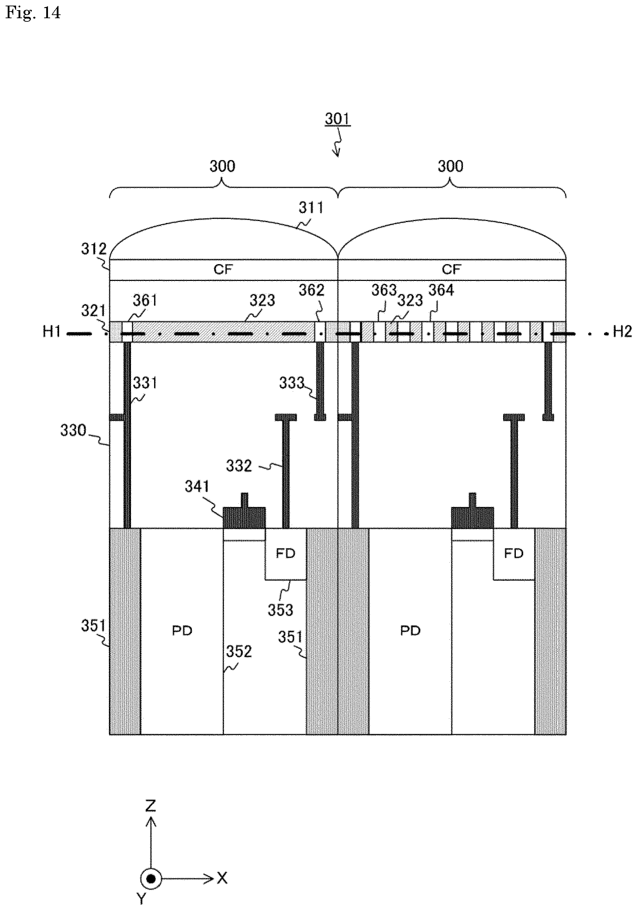

   Fig. 14 is an example of a cross-sectional view of a pixel according to a second embodiment of the present technique.
[Fig. 15]

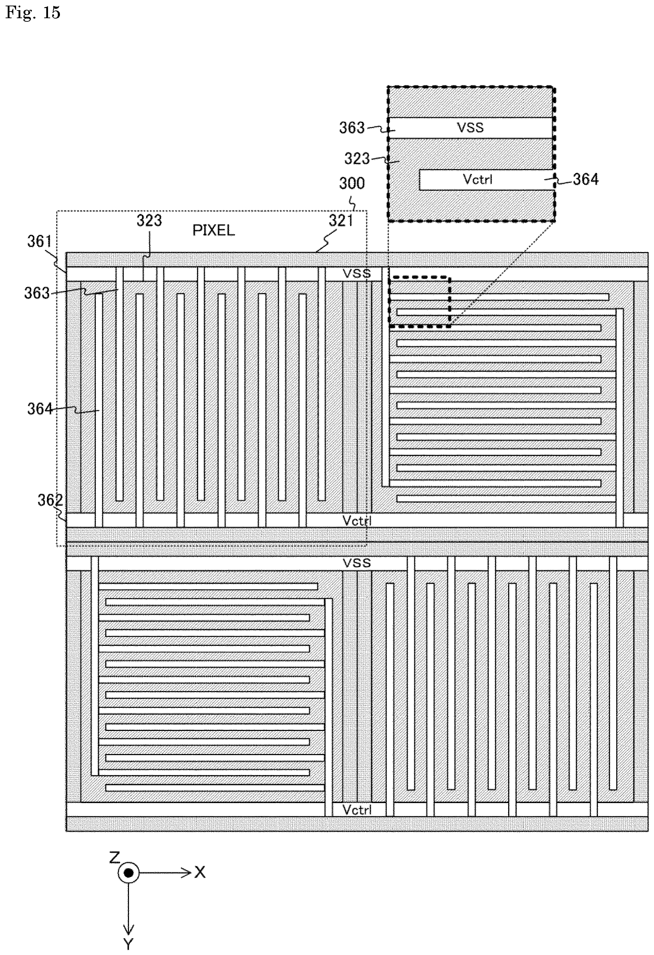

   Fig. 15 is a plan view illustrating an example of the layout of transparent electrodes and light modulating elements according to the second embodiment of the present technique.
[Fig. 16]

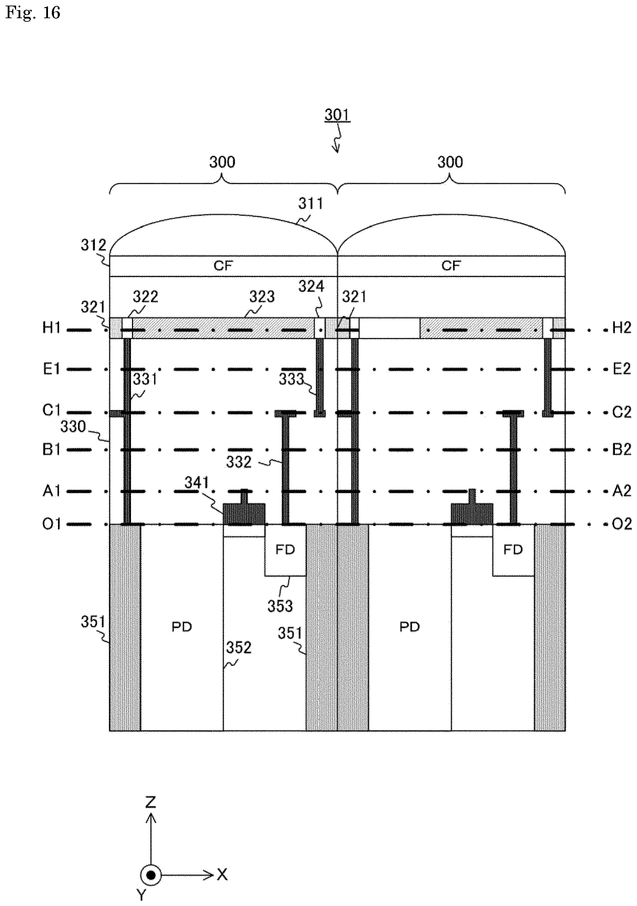

   Fig. 16 is an example of a cross-sectional view of a pixel according to a third embodiment of the present technique.
[Fig. 17]

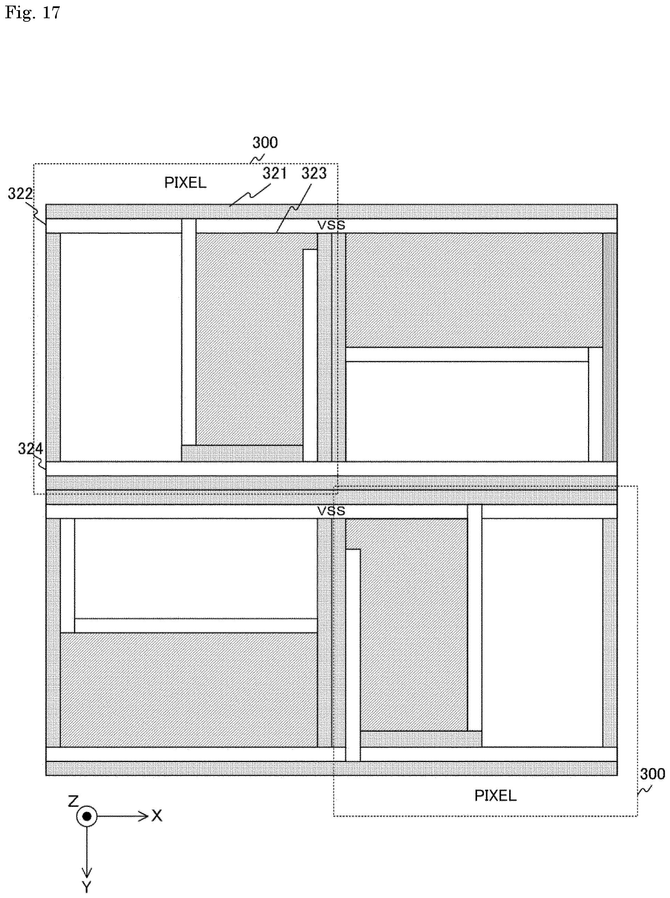

   Fig. 17 is a plan view illustrating an example of the layout of transparent electrodes and light modulating elements according to the third embodiment of the present technique.
[Fig. 18]

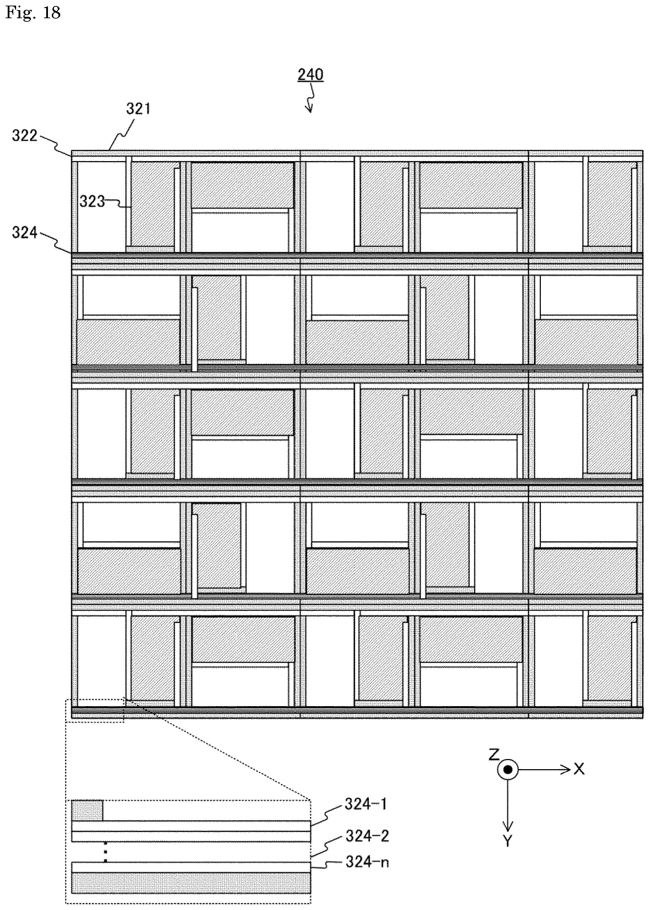

   Fig. 18 is a diagram illustrating an example of the layout of control lines according to the third embodiment of the present technique.
[Fig. 19]

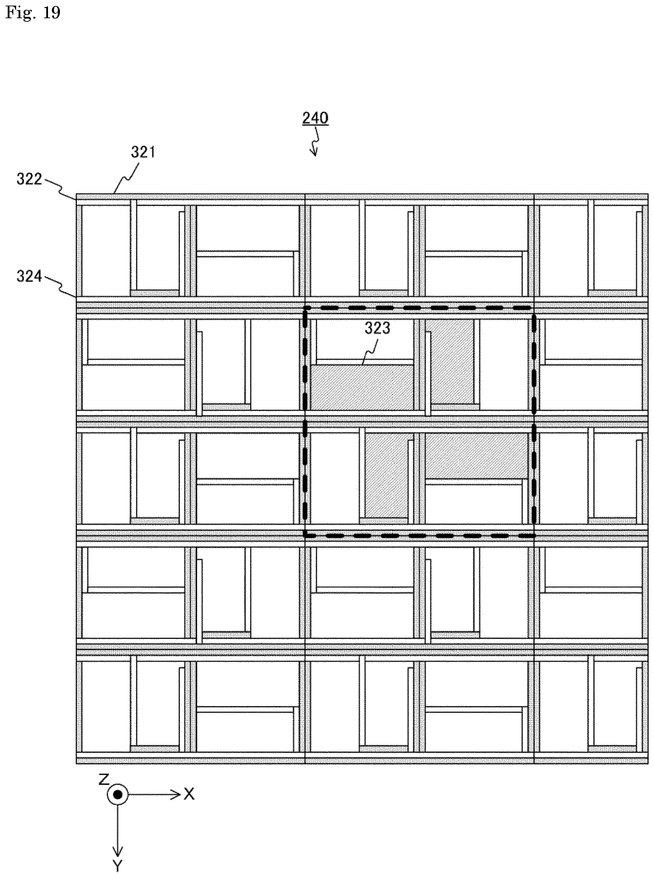

   Fig. 19 is a plan view illustrating an example of the layout of transparent electrodes and light modulating elements according to a first variation on the third embodiment of the present technique.
[Fig. 20]

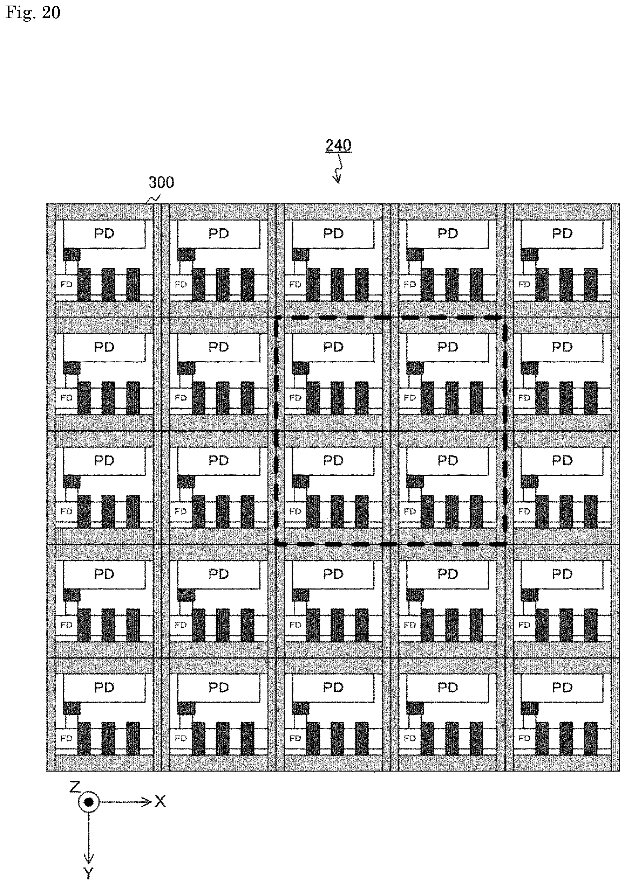

   Fig. 20 is a plan view illustrating an example of the layout of photodiodes and transistors according to a second variation on the third embodiment of the present technique.
[Fig. 21]

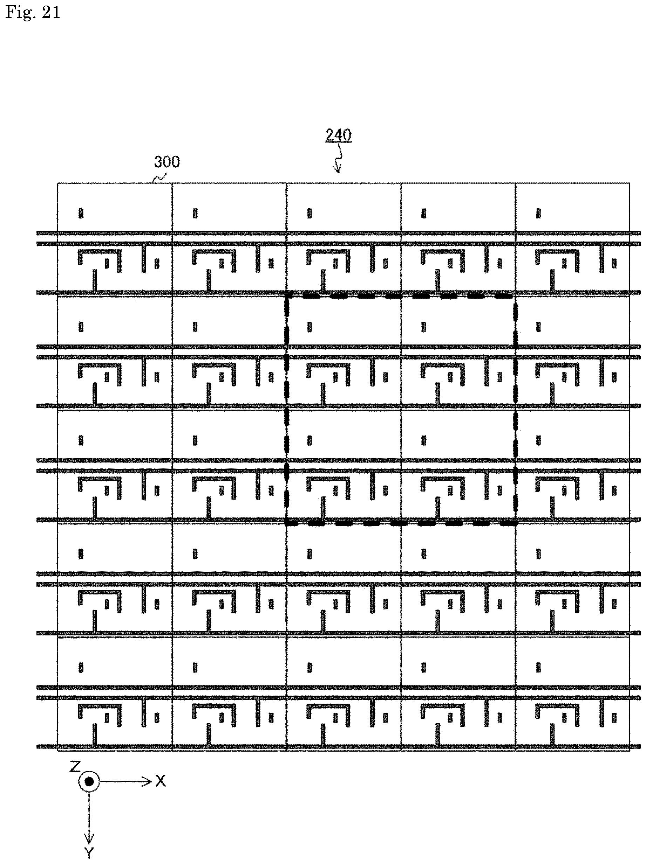

   Fig. 21 is a plan view illustrating an example of the wiring layout of signal lines in a row direction according to the second variation on the third embodiment of the present technique.
[Fig. 22]

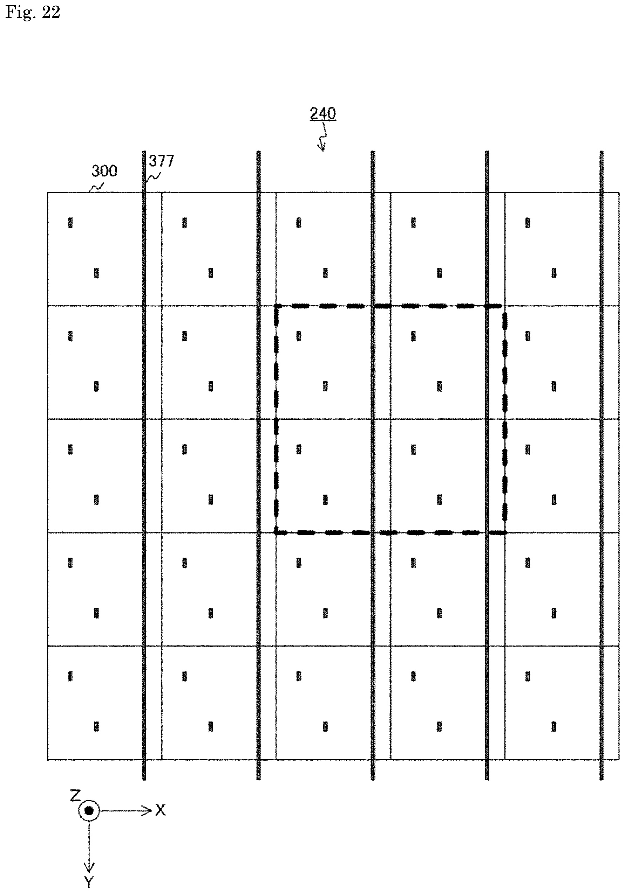

   Fig. 22 is a plan view illustrating an example of the wiring layout of signal lines in a column direction according to the second variation on the third embodiment of the present technique.
[Fig. 23]

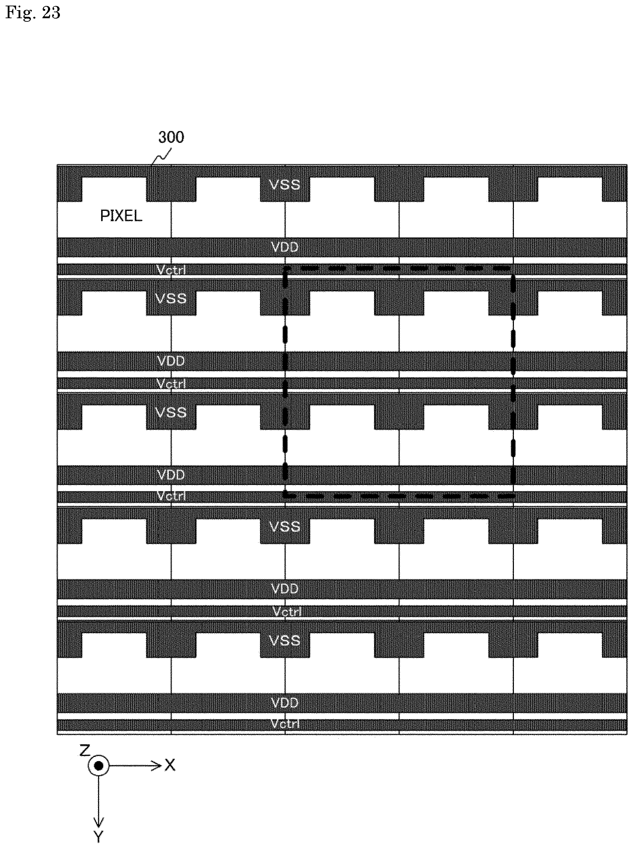

   Fig. 23 is a plan view illustrating an example of the wiring layout of power lines, ground lines, and control lines according to the second variation on the third embodiment of the present technique.
[Fig. 24]

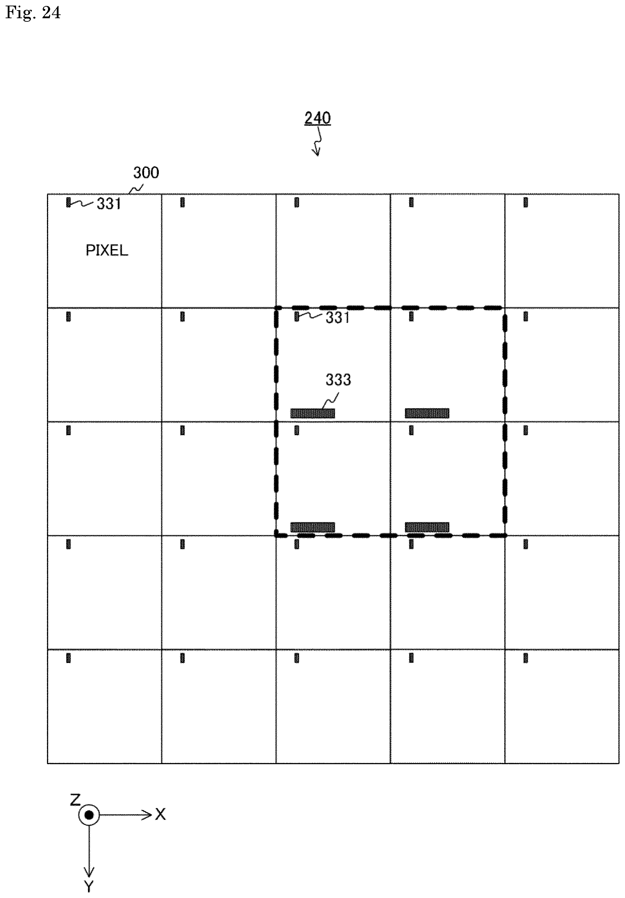

   Fig. 24 is a plan view illustrating an example of the arrangement of contacts of ground lines and control lines according to the second variation on the third embodiment of the present technique.
[Fig. 25]

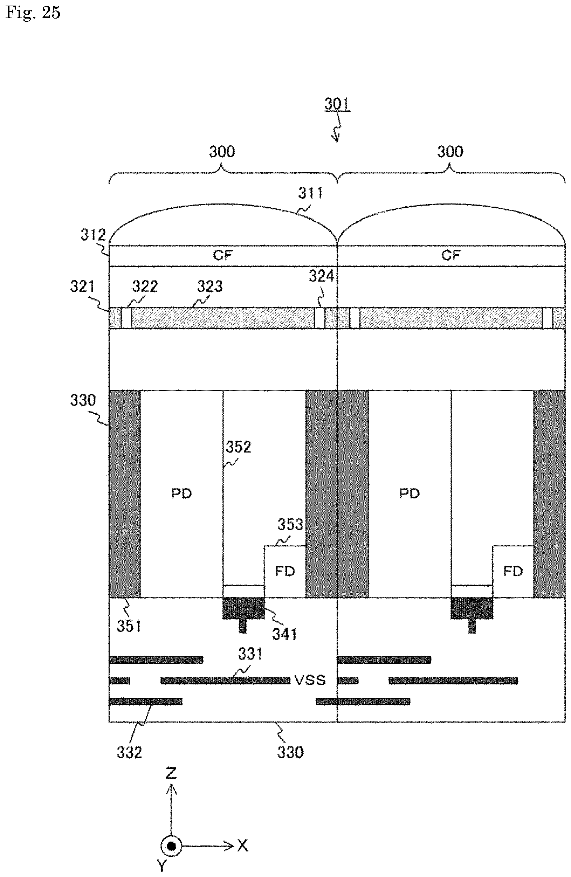

   Fig. 25 is an example of a cross-sectional view of a pixel according to a fourth embodiment of the present technique.
[Fig. 26]

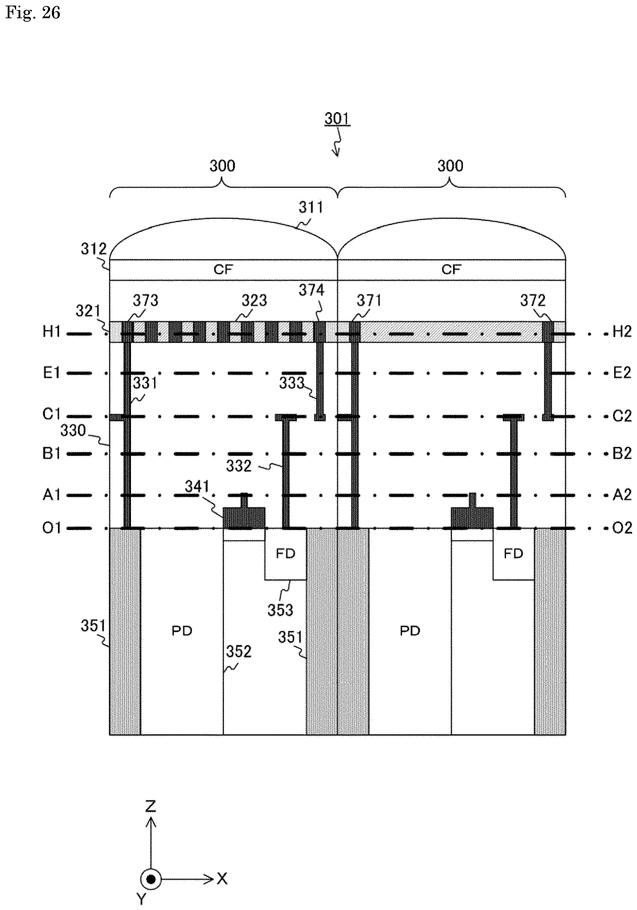

   Fig. 26 is an example of a cross-sectional view of a pixel according to a fifth embodiment of the present technique.
[Fig. 27]

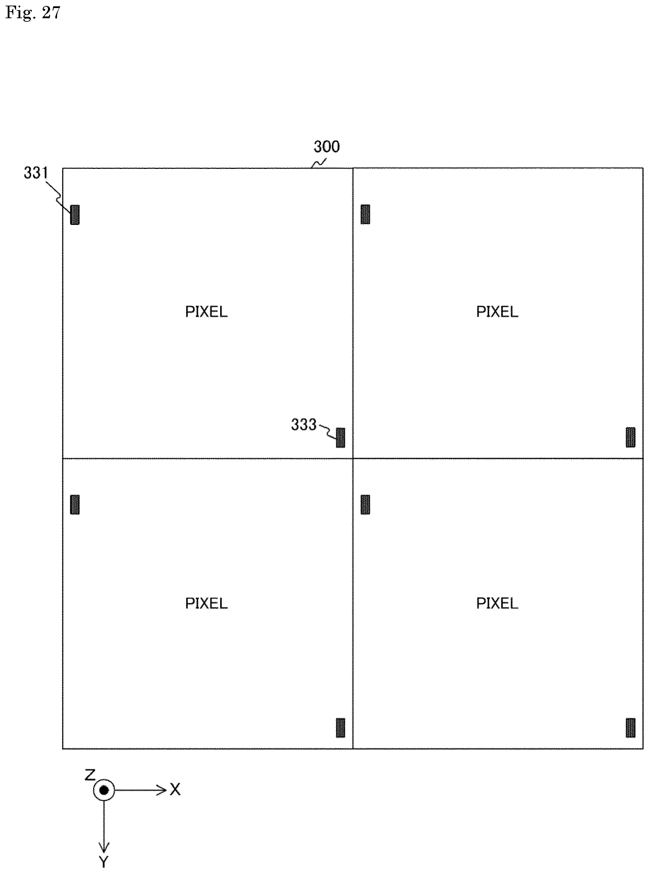

   Fig. 27 is a plan view illustrating an example of the arrangement of contacts of control lines and ground lines according to the fifth embodiment of the present technique.
[Fig. 28]

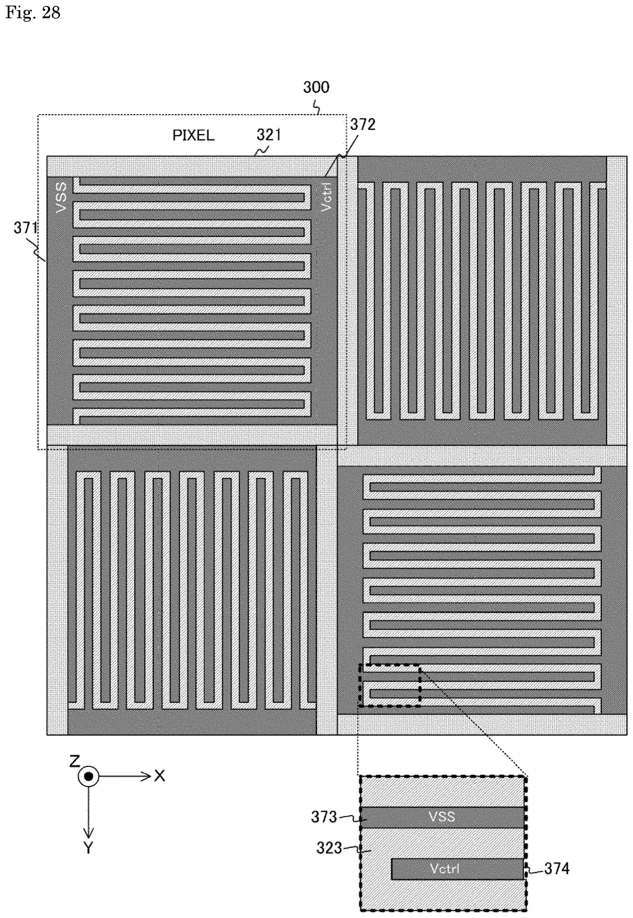

   Fig. 28 is a plan view illustrating an example of the layout of metal electrodes and light modulating elements according to the fifth embodiment of the present technique.
[Fig. 29]

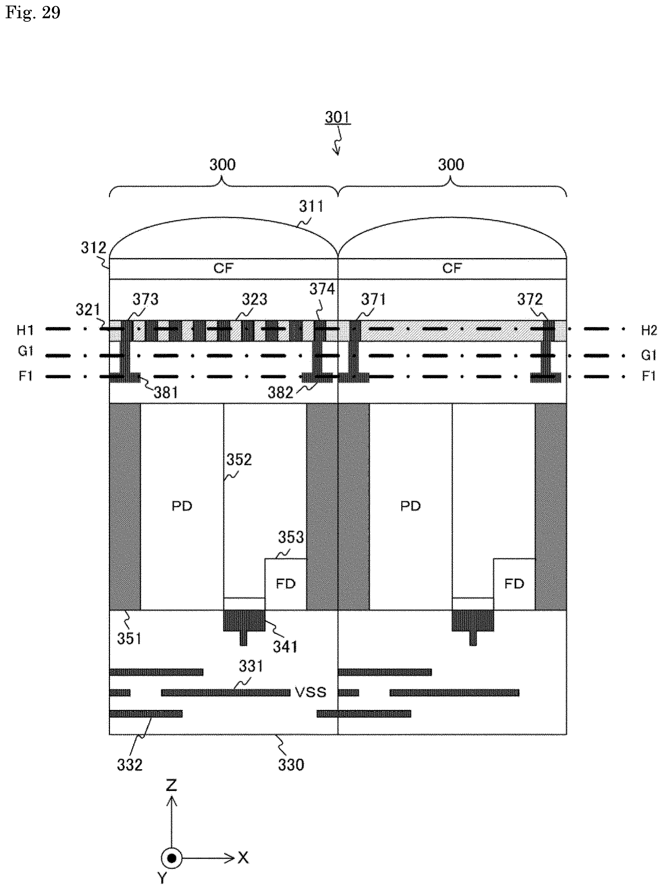

   Fig. 29 is an example of a cross-sectional view of a pixel according to a sixth embodiment of the present technique.
[Fig. 30]

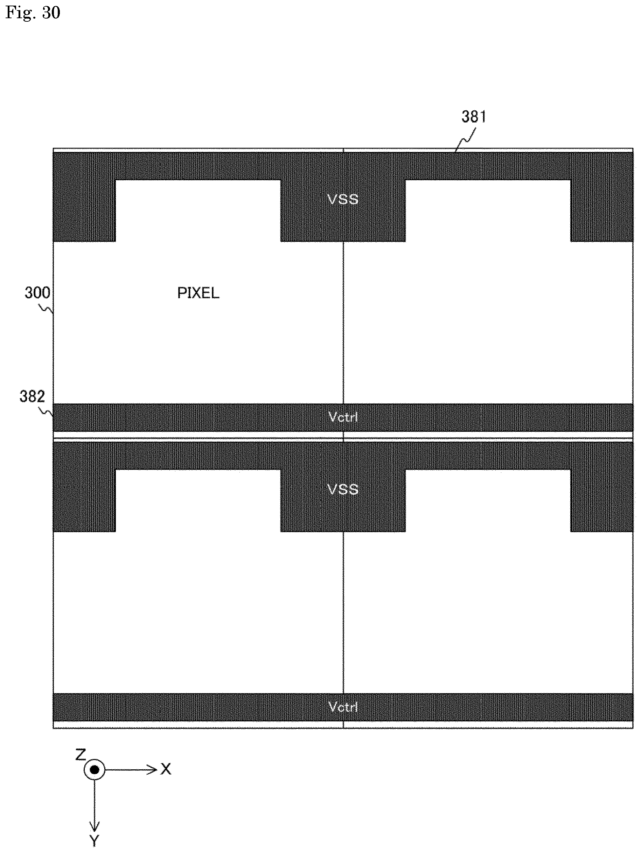

   Fig. 30 is a plan view illustrating an example of the wiring layout of ground lines and control lines according to the sixth embodiment of the present technique.
[Fig. 31]

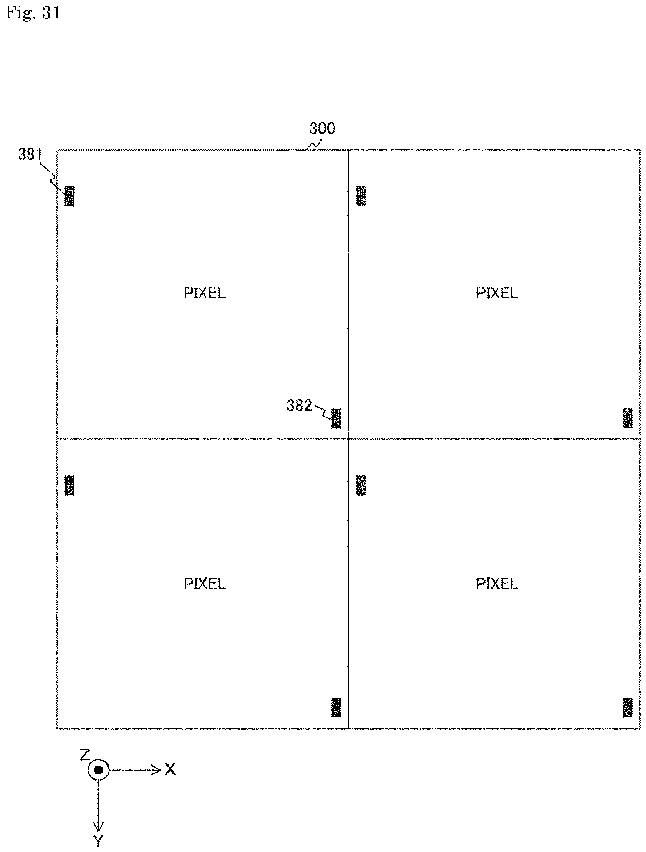

   Fig. 31 is a plan view illustrating an example of the arrangement of contacts of control lines and ground lines according to the sixth embodiment of the present technique.
[Fig. 32]

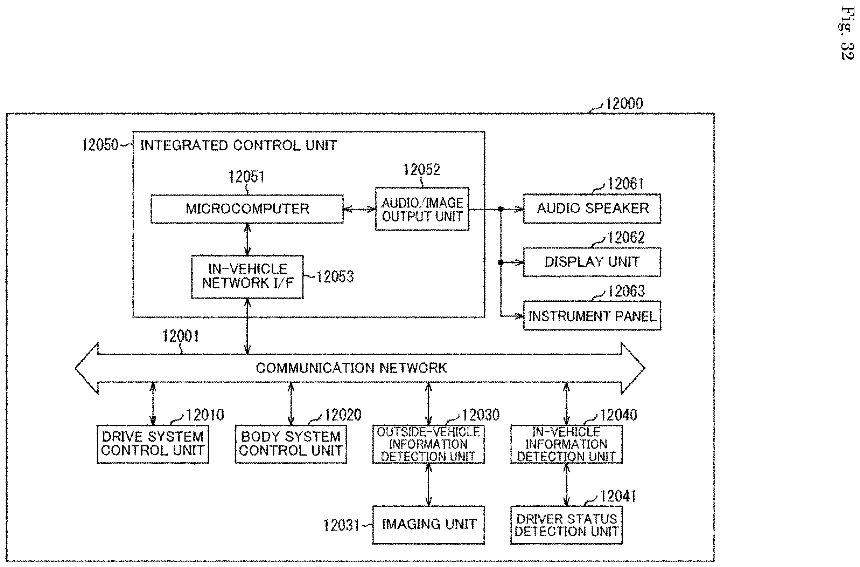

   Fig. 32 is a block diagram illustrating an example of the overall configuration of a vehicle control system.
[Fig. 33]

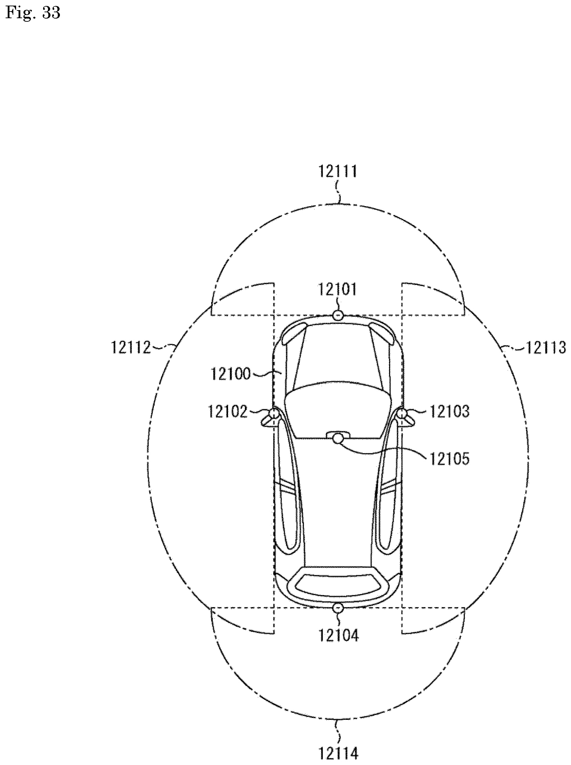

   Fig. 33 is a descriptive diagram illustrating an example of positions at which a vehicle exterior information detection unit and an imaging unit are installed.

### [Description of Embodiments]

Modes for implementing the present technique (hereinafter also referred to as "embodiments") will be described hereinafter. The descriptions will be given in the following order.
1. First Embodiment (an example in which a pair of transparent electrodes are arranged in a direction perpendicular to an optical axis)
2. Second Embodiment (an example in which a pair of transparent electrodes are arranged in a direction perpendicular to an optical axis, and a light control element has a comblike shape)
3. Third Embodiment (an example in which a pair of transparent electrodes are arranged in a direction perpendicular to an optical axis, and a phase difference is detected)
4. Fourth Embodiment (an example in which a pair of transparent electrodes are arranged in a direction perpendicular to an optical axis, and light is emitted onto a back surface)
5. Fifth Embodiment (an example in which a pair of metal electrodes are arranged in a direction perpendicular to an optical axis)
6. Sixth Embodiment (an example in which a pair of metal electrodes are arranged in a direction perpendicular to an optical axis, and light is emitted onto a back surface)
7. Example of Application in Moving Body

### <1. First Embodiment>

### [Configuration of Imaging Device]

Fig. 1 is a block diagram illustrating an example of the configuration of an imaging device 100 according to a first embodiment of the present technique. This imaging device 100 is a device for capturing image data, and includes an optical unit 110, a solid-state image sensor 200, and a DSP (Digital Signal Processing) circuit 120. The imaging device 100 further includes a display unit 130, an operating unit 140, a bus 150, frame memory 160, a storage unit 170, and a power supply unit 180. As the imaging device 100, for example, in addition to a digital camera such as a digital still camera, a smartphone, a personal computer, an in-vehicle camera, or the like having an imaging function may be used.

The optical unit 110 focuses light from a subject and guides the light to the solid-state image sensor 200. The solid-state image sensor 200 generates image data through photoelectric conversion in synchronization with a vertical synchronization signal. Here, the vertical synchronization signal is a periodic signal having a predetermined frequency that indicates the timing of image capture. The solid-state image sensor 200 supplies the generated image data to the DSP circuit 120 via a signal line 209.

The DSP circuit 120 executes predetermined image processing on the image data from the solid-state image sensor 200. The DSP circuit 120 outputs the processed image data to the frame memory 160 and the like via the bus 150. Note that the DSP circuit 120 is an example of a signal processing circuit described in the patent claims.

The display unit 130 displays the image data. As the display unit 130, for example, a liquid crystal panel or an organic EL (Electro Luminescence) panel may be used. The operating unit 140 generates an operation signal according to an operation by the user.

The bus 150 is a common channel for the optical unit 110, the solid-state image sensor 200, the DSP circuit 120, the display unit 130, the operating unit 140, the frame memory 160, the storage unit 170, and the power supply unit 180 to exchange data with each other.

The frame memory 160 holds the image data. The storage unit 170 stores various types of data, such as the image data. The power supply unit 180 supplies power to the solid-state image sensor 200, the DSP circuit 120, the display unit 130, and the like.

### [Example of Configuration of Solid-State Image Sensor]

Fig. 2 is a block diagram illustrating an example of the configuration of the solid-state image sensor 200 according to the first embodiment of the present technique. This solid-state image sensor 200 includes a vertical scanning circuit 210, a DAC 220, a timing control circuit 230, a pixel array unit 240, a column signal processing circuit 250, and a horizontal scanning circuit 260.

A plurality of pixels 300 are arranged in a two-dimensional grid in the pixel array unit 240. Hereinafter, the collection of pixels 300 arranged in a predetermined horizontal direction will be referred to as "rows", and the collection of pixels 300 arranged in a direction perpendicular to the horizontal direction will be referred to as "columns".

The timing control circuit 230 controls the operation timing of the vertical scanning circuit 210, the column signal processing circuit 250, and the like in synchronization with the vertical synchronization signal.

The vertical scanning circuit 210 selects and drives the rows in order, and outputs analog pixel signals. The DAC 220 generates a reference signal through DA (Digital to Analog) conversion and supplies the reference signal to the column signal processing circuit 250. A sawtooth ramp signal, for example, is used as the reference signal. The pixels 300 generate the pixel signals through photoelectric conversion under the control of the vertical scanning circuit 210. Each of the pixels 300 outputs a pixel signal to the column signal processing circuit 250.

The column signal processing circuit 250 performs signal processing such as CDS (Correlated Double Sampling) processing and AD conversion processing on the pixel signals on a column-by-column basis. The column signal processing circuit 250 supplies image data constituted by digital signals after the signal processing to the DSP circuit 120 under the control of the horizontal scanning circuit 260.

The horizontal scanning circuit 260 selects the columns in order and outputs digital signals to the column signal processing circuit 250 in order.

### [Example of Configuration of Pixel]

Fig. 3 is an example of a cross-sectional view of the pixel 300 according to the first embodiment of the present technique. Hereinafter, the optical axis of incident light will be referred to as a "Z axis", and an axis parallel to the rows in the pixel array unit 240 in a plane perpendicular to the Z axis will be referred to as an "X axis". An axis parallel to the columns in the pixel array unit 240, i.e., an axis perpendicular to the Z axis and X axis, will be referred to as a "Y axis". The figure is a cross-sectional view of the pixel 300 seen in the Y axis direction.

Each of the pixels 300 is formed on a semiconductor substrate 301. Elements such as a photodiode 352, a floating diffusion layer 353, and the like are disposed in each of the pixels 300. The elements such as the photodiode 352 are separated from the adjacent pixels 300 by an element separation region 351.

A wiring layer 330 is formed on a top part of the photodiode 352 with the direction toward the optical unit 110 as the upward direction. A plurality of wires including a ground line 331, a power line 332, and a control line 333, and transistors such as a transfer transistor 341, are provided in this wiring layer 330. The potential of the ground line 331 is a predetermined ground potential VSS. A predetermined power supply voltage VDD is applied to the power line 332. In addition, a control voltage Vctrl is applied to the control line 333 to control the transmittance of a light control element 323, which will be described later.

Transparent electrodes 322 and 324 are disposed for each pixel 300 on a top part of the wiring layer 330. These transparent electrodes 322 and 324 are arranged along a direction (the X axis direction or the Y axis direction) perpendicular to the optical axis (i.e., the Z axis). For example, indium tin oxide (ITO) is used for the transparent electrodes 322 and 324. In addition, tin oxide (SnO₂) or indium oxide (In₂O) can be used for the transparent electrodes 322 and 324. The transparent electrode 322 is connected to the ground line 331, and the potential thereof is the ground potential VSS. On the other hand, the transparent electrode 324 is connected to the control line 333, and the control voltage Vctrl is applied to the transparent electrode 324.

The light control element 323 is disposed between the transparent electrode 322 and the transparent electrode 324. This light control element 323 is a device that transmits incident light through transmittance according to the control voltage Vctrl between the transparent electrodes 322 and 324. For example, a suspended particle device (SPD) is used as the light control element 323.

The suspended particle device contains a large number of particles, and when the voltage value of the control voltage Vctrl is zero (i.e., no voltage is applied), the individual particles are aligned in a predetermined direction (e.g., the optical axis direction), which maximizes the light transmittance. On the other hand, when a voltage is applied, the particles are aligned in a direction perpendicular to the optical axis and the transmittance becomes lower than when no voltage is applied. The higher the voltage value is, the lower the transmittance becomes.

Note that the transparent electrodes 322 and 324 are an example of a pair of electrodes described in the claims.

A circuit external to the pixel 300 (e.g., the DSP circuit 120) can adjust the transmitted light intensity by changing the transmittance of the light control element 323 according to the control voltage Vctrl. For example, when sensing the shape of an object (e.g., one's own face) with a smartphone camera, if a picture is taken with the sun in the background, there is a possibility of halation arising and sensing will not be able to be performed properly. In such a case, this problem can be solved by adjusting the control voltage Vctrl applied to the transparent electrodes 322 and 324 between which the light control element 323 is interposed in stages to achieve the optimal transmittance. Cameras for determining whether road surfaces are frozen or not, identifying a person in a vehicle, and the like are also expected to be used in situations under strong light like the sun, and therefore face similar dynamic range problems. These can also be solved using the methods described earlier. Specifically, the DSP circuit 120 and the like meter the incident light intensity, and as the metered light intensity increases, the control voltage Vctrl is reduced to reduce the transmittance.

In addition, an oxide film 321 is provided around the transparent electrodes 322 and 324 and the light control element 323.

A color filter 312 is formed on a top part of the light control element 323, and an on-chip lens 311 is formed on a top part of the color filter 312.

As illustrated in the figure, the wiring layer 330 is disposed between the light control element 323 and the photodiode 352, and of the two surfaces of the semiconductor substrate 301, light is irradiated to the side (i.e., surface) on which the wiring layer 330 is formed. For this reason, the solid-state image sensor 200 having this configuration is called a front surface-irradiated solid-state image sensor.

Although an SPD is used as the light control element 323, an element aside from an SPD may be used instead as long as the transmitted light intensity can be adjusted. For example, an electrochromic element is an element that changes color by controlling the voltage applied thereto, and can be used as the light control element 323. An oxidized coloring layer is a layer that is originally transparent, but develops color when oxidized, and is constituted by iridium oxide, for example. In electrochromic elements, oxides or hydroxides of iridium, nickel, chromium, vanadium, ruthenium, rhodium, or the like can be used for the oxidized coloring layer. When iridium oxide is used for the oxidized coloring layer, the layer turns gray when colored. A reduced coloring layer is a layer that is originally transparent, but develops color when reduced, and is constituted by tungsten oxide (WO₃), for example. Molybdenum oxide (MoO₃) can also be used. When tungsten oxide is used for the reduced coloring layer, the layer turns blue when colored. In an electrochromic element configured as described above, when a voltage is applied to the interposed electrodes, the oxidized coloring layer and the reduced coloring layer are oxidized and reduced, respectively, and become colored and opaque.

A composite device of polymer and liquid crystals can also be used as the light control element 323. A polymer-liquid crystal composite device is formed, for example, by placing a composite layer of polymer and liquid crystals between two opposing transparent electrodes. When a voltage is applied to the electrodes, the orientation directions of the liquid crystal molecules are aligned, resulting in a transparent state. On the other hand, when no voltage is applied between the electrodes, the liquid crystal molecules are oriented essentially randomly according to the surrounding polymer network, which scatters incident light. In other words, the polymer-liquid crystal composite device becomes opaque.

Although what is known as a PNLC (Polymer Network Liquid Crystal) is described here, what is known as a PDLC (Polymer Dispersed Liquid Crystal), in which liquid crystal molecules are discontinuously distributed throughout a polymer, can also be used as the light control element 323 in a similar manner. In addition, graphene can also be used as the light control element 323.

Fig. 4 is a plan view illustrating an example of the layout of the photodiode 352 and transistors according to the first embodiment of the present technique. The figure illustrates an X-Y plane through an O1-O2 axis indicated in Fig. 3.

The photodiode 352, the transfer transistor 341, the floating diffusion layer 353, a reset transistor 342, an amplifying transistor 343, and a selection transistor 344 are arranged in each of the pixels 300. In addition, the element separation region 351 is provided around these elements.

The photodiode 352 converts incident light into an electrical charge. The transfer transistor 341 transfers the charge from the photodiode 352 to the floating diffusion layer 353 under the control of the vertical scanning circuit 210.

The floating diffusion layer 353 accumulates the charge and generates a voltage according to the charge amount. The reset transistor 342 initializes the charge amount of the floating diffusion layer 353 under the control of the vertical scanning circuit 210. The amplifying transistor 343 amplifies the voltage of the floating diffusion layer 353. The selection transistor 344 outputs a signal resulting from amplifying the voltage to a vertical signal line as a pixel signal under the control of the vertical scanning circuit 210.

Although four transistors, such as the transfer transistor 341, are disposed in the pixel 300, the number of transistors is not limited to four, and may be five, six, or the like.

Fig. 5 is a plan view illustrating an example of the wiring layout of signal lines in the row direction according to the first embodiment of the present technique. The figure illustrates the X-Y plane through an A1-A2 axis indicated in Fig. 3.

For each row, a transfer line 334, a selection line 335, and a reset line 338 are wired along the X axis direction (in other words, in the row direction). The vertical scanning circuit 210 supplies a transfer signal TG for driving the transfer transistor 341 over the transfer line 334 and a selection signal SEL for driving the selection transistor 344 over the selection line 335. The vertical scanning circuit 210 also supplies a reset signal RST for driving the reset transistor 342 over the reset line 338.

An FD line 336 is also provided in the pixel 300. This FD line 336 is routed between the photodiode 352 and the floating diffusion layer 353.

In the pixel 300, the ground line 331, the power line 332, and the vertical signal line 337 are routed along the Z axis direction. The black rectangles in Fig. 5 represent the cross-section of these wires in the Z axis direction. Here, a vertical signal line 337 is a signal line that transmits pixel signals.

Fig. 6 is a plan view illustrating an example of the wiring layout of the signal lines in a column direction according to the first embodiment of the present technique. The figure illustrates the X-Y plane through a B1-B2 axis indicated in Fig. 3.

For each row, vertical signal lines 337 are wired along the Y axis direction (in other words, the column direction). The vertical signal line 337 branches in the Z axis direction and is connected to the selection transistor 344 for each pixel 300.

Additionally, in the pixel 300, the ground line 331 and the power line 332 are routed along the Z axis direction. The black rectangles in Fig. 6 represent the cross-section of these wires in the Z axis direction.

Fig. 7 is a plan view illustrating an example of the wiring layout of the power line 332, the ground line 331, and the control line 333 according to the first embodiment of the present technique. The figure illustrates the X-Y plane through a C1-C2 axis indicated in Fig. 3.

For each row, the power line 332, the ground line 331, and the control line 333 are routed along the X axis direction (the row direction). The ground line 331 and the control line 333 branch in the Z axis direction and are connected to the transparent electrodes 322 and 324 for each pixel 300.

Fig. 8 is a plan view illustrating an example of the arrangement of contacts of the ground line 331 and the control line 333 according to the first embodiment of the present technique. The figure illustrates the X-Y plane through an E1-E2 axis indicated in Fig. 3.

In the pixel 300, the ground line 331 and the control line 333 are routed along the Z axis direction. The black rectangles in Fig. 8 represent the contacts, which are connection points of the ground line 331 connected to the transparent electrode 322, and the connection points (contacts) of the control line 333 connected to the transparent electrode 324.

Fig. 9 is a plan view illustrating an example of the layout of the transparent electrodes 322 and 324 and the light control element 323 according to the first embodiment of the present technique. The figure illustrates the X-Y plane through an H1-H2 axis indicated in Fig. 3.

The transparent electrodes 322 and 324 are arranged along the Y axis direction perpendicular to the optical axes (the Z axis). The transparent electrodes 322 and 324 are linear and are formed along the X axis direction. The light control element 323, which has a plate shape, is disposed between the transparent electrode 322 and the transparent electrode 324. The light control element 323 is formed in a region that covers the entire photodiode 352 in the X-Y plane.

The potential of the transparent electrode 322 is the ground potential VSS, and the control voltage Vctrl is applied to the transparent electrode 324. The light control element 323 transmits incident light at a transmittance corresponding to the control voltage Vctrl.

Fig. 10 is a diagram illustrating an example of the trajectory of incident light when the control voltage Vctrl is low (a voltage of zero or the like) according to the first embodiment of the present technique. The white arrow in the figure indicates the trajectory of the incident light. The lower the control voltage Vctrl is, the higher the transmittance of the light control element 323 becomes.

A distance from the surface of the color filter 312 to the surface of the photodiode 352 is assumed to be Z₁, and the thickness of the light control element 323 is assumed to be Z₀. It is also assumed that the incident light is incident on a predetermined position of the surface of the color filter 312 at a predetermined incident angle. This incident light is incident on the surface of the photodiode 352, for example, according to an incident angle.

Fig. 11 is a diagram illustrating an example of the trajectory of incident light when the control voltage Vctrl is high according to the first embodiment of the present technique. The white arrow in the figure indicates the trajectory of the incident light. The higher the control voltage Vctrl is, the lower the transmittance of the light control element 323 becomes. This results in a lower transmitted light intensity.

Here, consider a comparative example in which transparent electrodes are placed at a top part and a bottom part of the light control element. In this comparative example, the elements are stacked in the optical axis (Z axis) in order from the upper transparent electrode, the light control element, and the lower transparent electrode.

Fig. 12 is a diagram illustrating an example of the trajectory of incident light when the control voltage is high according to the comparative example. The white arrow in the figure indicates the trajectory of the incident light. In the comparative example, the higher the control voltage is, the higher the transmittance of the light control element becomes.

In this comparative example, the location where the incident light is incident and the incident angle are assumed to be the same as in Figs. 10 and 11. The thickness of each of the upper transparent electrode and the lower transparent electrode is assumed to be Z₂. The distance from the surface of the color filter to the upper transparent electrode and the thickness of the wiring layer are assumed to be similar to those in Figs. 10 and 11. In this case, in the comparative example, the transparent electrodes are stacked, and thus the distance from the surface of the color filter to the surface of the photodiode is Z₁+2×Z₂. In this manner, the distance from the surface of the color filter to the surface of the photodiode is increased by the amount corresponding to the stacked transparent electrodes (i.e., 2×Z₂). Due to the longer distance to the photodiode, in the comparative example, some of the incident light incident at an angle is blocked by the wiring in the wiring layer, which increases the likelihood of vignetting.

In contrast, as illustrated in Figs. 10 and 11, when the transparent electrodes 322 and 324 are arranged along the direction perpendicular to the optical axis and the light control element 323 is disposed therebetween, the distance to the photodiode can be set to a shorter value (Z₁) than in the comparative example. This prevents vignetting when light is incident at an angle. In other words, the oblique incidence characteristics can be improved. Improving the oblique incidence characteristics makes it possible to broaden the dynamic range.

Fig. 13 is a diagram illustrating an example of the trajectory of incident light when the control voltage is low according to the comparative example. In the comparative example, the lower the control voltage is, the lower the transmittance of the light control element becomes, and the transmitted light intensity decreases as a result.

In this manner, according to the first embodiment of the present technique, the transparent electrodes 322 and 324 are arranged along the direction perpendicular to the optical axis and the light control element 323 is disposed therebetween, and thus the distance to the photodiode can be shortened compared to the case where the stated elements are stacked. This makes it possible to suppress vignetting caused by the wiring of the wiring layer and improve the image quality of the image data.

### <2. Second Embodiment>

In the first embodiment described above, the light control element 323 is disposed between the transparent electrodes 322 and 324, but the required voltage increases as the transmittance decreases, which increases the power consumption. The solid-state image sensor 200 of the second embodiment differs from the first embodiment in that the shape of the light control element 323 is set to a comb-like shape to reduce power consumption.

Fig. 14 is an example of a cross-sectional view of the pixel 300 according to the second embodiment of the present technique.

Fig. 15 is a plan view illustrating an example of the layout of transparent electrodes and the light control element 323 according to the second embodiment of the present technique. The figure illustrates a plane through an H1-H2 axis indicated in Fig. 14.

The light control element 323 of the second embodiment differs from the first embodiment in that the element has a comblike shape in which a plurality of slits are formed. Each of the slits is formed along a specific direction perpendicular to the optical axis (the X axis direction or the Y axis direction). For example, a slit is formed along the Y axis direction in the upper-left pixel 300 and the lower-right pixel 300, and a slit is formed along the X axis direction in the upper-right pixel 300 and the lower-left pixel 300.

The transparent electrode on the ground side has a linear connection part 361 and a plurality of protruding parts 363, and the transparent electrode on the power supply side has a linear connection part 362 and a plurality of protruding parts 364.

The linear connection part 361 is connected to a ground line, and the potential thereof is the ground potential VSS. On the other hand, the linear connection part 362 is connected to a power line, and the control voltage Vctrl is applied thereto. These linear connection parts 361 and 362 extend along a direction (e.g., the X axis direction) perpendicular to the optical axis (the Z axis) and the direction in which the transparent electrodes are arranged (e.g., the Y axis direction).

The protruding parts 363 are connected to the linear connection part 361 on the ground side and protrude along the direction of the slits (the X axis direction or the Y axis direction). On the other hand, the protruding parts 364 are connected to the linear connection part 362 on the power supply side and protrude along the direction of the slits. For example, in the upper-left pixel 300, a slit is formed along the Y axis direction, and the protruding parts 363 branch out and protrude in the downward direction from the linear connection part 361 on the upper side. From the linear connection part 362 on the lower side, the protruding parts 364 branch out and protrude in the upward direction. The protruding parts 363 and 364 are disposed in an alternating manner in respective ones of the plurality of slits.

As illustrated in the figure, by forming a plurality of slits in the light control element 323 and disposing the protruding parts 363 and 364 of the transparent electrodes in those slits, the control voltage Vctrl can be applied to the parts of the light control element 323 interposed between the slits. Because the resistance of the part interposed between the slits is lower than the resistance of the light control element 323 lacking the slits, the control voltage Vctrl required to control the transmittance to a target transmittance can be lower than when the slits are not provided. Accordingly, reducing the required control voltage Vctrl makes it possible to reduce the power consumption.

In this manner, according to the second embodiment of the present technique, because the plurality of slits are formed in the light control element 323, and the protruding parts 363 and 364 of the transparent electrodes are disposed therein, the control voltage Vctrl required for driving can be lower than when the slits are not provided. This makes it possible to reduce the power consumption.

### <3. Third Embodiment>

In the first embodiment described above, the light control element 323 is disposed in a region covering the entire photodiode, but this configuration cannot detect a phase difference between the pixel signals of a pair of pixels which have been pupil-divided. The solid-state image sensor 200 of the third embodiment differs from the first embodiment in that phase detection pixels for detecting phase differences are provided.

Fig. 16 is an example of a cross-sectional view of the pixel 300 according to the third embodiment of the present technique.

Fig. 17 is a plan view illustrating an example of the layout of the transparent electrodes 322 and 324 and the light control element 323 according to the third embodiment of the present technique. The figure illustrates a plane through an H1-H2 axis indicated in Fig. 16.

The light control element 323 of the third embodiment differs from the first embodiment in that the light control element 323 is formed in a region that covers part of the photodiode. For example, the light control element 323 on the upper-left is formed in a region covering the right side, and the light control element 323 on the lower-right is formed in a region covering the left side. Additionally, the light control element 323 on the lower-left is formed in a region covering the lower side, and the light control element 323 on the upper-right is formed in a region covering the upper side.

Fig. 18 is a diagram illustrating an example of the layout of control lines according to the third embodiment of the present technique. In the third embodiment, n power supply side transparent electrodes 324-1 to 324-n (where n is an integer) are provided for each row. Each of the rows is divided into n areas, and the n transparent electrodes are connected to mutually-different areas. This makes it possible for a circuit outside the pixel 300 (the vertical scanning circuit 210 or the like) to control the control voltage Vctrl individually for each of the n areas.

When the DSP circuit 120 or the like finds the in-focus position of the lens for a part of the pixel array unit 240, the vertical scanning circuit 210 and the like use the control voltage Vctrl to set the light control element 323 in each pair of pixels in that part to be opaque. The light control element 323 of the pixel 300 for which the in-focus position is not found is controlled to be transparent. The pair of pixels 300 where the light control element 323 is opaque functions as a phase detection pixel for detecting a phase difference. Here, a pair of pixels at positions of the light control element 323 which are symmetrical to each other are used as phase difference pixels. For example, a pixel in which the light control element 323 is formed on the right side and a pixel in which the light control element 323 is formed on the left side are used as phase detection pixels.

Then, the DSP circuit 120 or the like detects the phase difference from the signals of a plurality of the pairs of phase detection pixels, finds an in-focus position corresponding to the phase difference, and moves the lens to that position. This makes it possible to realize an AF (Auto Focus) function.

As illustrated in the figure, because there are n control lines per row, the vertical scanning circuit 210 can cause pixels in any area of the n areas to be opaque and function as phase detection pixels.

In this manner, according to the third embodiment of the present technique, because the light control element 323 is formed in a region covering part of the photodiode, the vertical scanning circuit 210 and the like can detect a phase difference by making the light control element 323 opaque. An AF function can then be realized by moving the lens to the in-focus position according to the phase difference.

### [First Variation]

In the third embodiment described above, the light control element 323 is disposed in all the pixels 300, but in this configuration, the sensitivity of the pixels 300 may be reduced compared to a case where the light control element 323 is not provided in all the pixels 300. The solid-state image sensor 200 of the first variation on the third embodiment differs from the third embodiment in that the light control element 323 is disposed only in some of the pixels 300 in the pixel array unit 240.

Fig. 19 is a plan view illustrating an example of the layout of the transparent electrodes 322 and 324 and the light control element 323 according to the first variation on the third embodiment of the present technique. This layout of the first variation on the third embodiment differs from the third embodiment in that the light control element 323 is disposed only in some of the plurality of pixels 300 in the pixel array unit 240, and the light control element 323 is not disposed in the remaining pixels 300. For example, the light control element 323 is disposed in the four pixels 300 surrounded by the bold dotted lines in the figure. The pixels in which the light control element 323 is disposed function as phase detection pixels. Unlike the third embodiment, in which any pixel can be used as a phase detection pixel, in the first variation on the third embodiment, the positions of the phase detection pixels are fixed.

Even when the transmittance of the light control element 323 is set to the highest value, the transmittance is usually not 100%. Accordingly, disposing the light control element 323 only in some of the pixels 300 makes it possible to improve the sensitivity of the pixels not provided with the light control element 323 compared to a case where all of the pixels are provided with the light control element 323.

In the first variation on the third embodiment, one transparent electrode 324 is wired for each row, as in the first embodiment. Additionally, in the first variation on the third embodiment, transmittance control according to the metered light intensity is not executed.

In this manner, according to the first variation on the third embodiment of the present technique, the light control element 323 is disposed only in some of the pixels 300 of the pixel array unit 240, which makes it possible to improve the sensitivity of the pixels not provided with the light control element 323 compared to a case where all of the pixels are provided with the light control element 323.

### [Second Variation]

In the third embodiment described above, n control lines are provided for each row, and the control lines are connected to each pixel, but in this configuration, the number of contacts increases as the number of pixels increases. The solid-state image sensor 200 of a second variation on the third embodiment differs from the third embodiment in that the control lines are connected only to some of the pixels 300 in the pixel array unit 240.

The cross-sectional view of the pixel 300 of the second variation on the third embodiment is similar to the cross-sectional view in the third embodiment, illustrated in Fig. 16.

Fig. 20 is a plan view illustrating an example of the layout of the photodiode 352 and transistors according to the second variation on the third embodiment of the present technique. The figure illustrates an X-Y plane through an O1-O2 axis indicated in Fig. 16.

The individual layouts of the pixels 300 in the second variation on the third embodiment are similar to those in the first embodiment. However, in the second variation on the third embodiment, only some of the plurality of pixels 300 in the pixel array unit 240 function as phase detection pixels. For example, the four pixels 300 surrounded by bold dotted lines in the figure function as phase detection pixels. Unlike the third embodiment, in which any pixel can be used as a phase detection pixel, in the second variation on the third embodiment, the positions of the phase detection pixels are fixed.

Fig. 21 is a plan view illustrating an example of the wiring layout of signal lines in a row direction according to the second variation on the third embodiment of the present technique. The figure illustrates the X-Y plane through an A1-A2 axis indicated in Fig. 16. The wiring layout in the second variation on the third embodiment is similar to that in the first embodiment.

Fig. 22 is a plan view illustrating an example of the wiring layout of signal lines in a column direction according to the second variation on the third embodiment of the present technique. The figure illustrates the X-Y plane through a B1-B2 axis indicated in Fig. 16. The wiring layout in the second variation on the third embodiment is similar to that in the first embodiment.

Fig. 23 is a plan view illustrating an example of the wiring layout of power lines, ground lines, and control lines according to the second variation on the third embodiment of the present technique. The figure illustrates the X-Y plane through a C1-C2 axis indicated in Fig. 16. The wiring layout in the second variation on the third embodiment is similar to that in the first embodiment.

Fig. 24 is a plan view illustrating an example of the arrangement of contacts of ground lines and control lines according to the second variation on the third embodiment of the present technique. The figure illustrates the X-Y plane through an E1-E2 axis indicated in Fig. 16. As illustrated in the figure, in the second variation on the third embodiment, the contacts of the control line 333 are formed only in the pixels 300 that correspond to the phase detection pixels, which are surrounded by the bold dotted lines. Contacts for the ground line 331 are formed in all the pixels. The ground line 331 is connected to all the pixels, and the ground line 331 and control line 333 are connected to the transparent electrodes 322 and 324 in the phase detection pixels.

As illustrated in the figure, by connecting the control line 333 only to the phase difference pixels, the number of contacts can be reduced compared to the case where the control line 333 is connected to all the pixels. Note that in the second variation on the third embodiment, transmittance control according to the metered light intensity is not executed.

Additionally, the layout of the transparent electrodes 322 and 324 and the light control element 323 according to the second variation on the third embodiment of the present technique is similar to the layout in the third embodiment, illustrated in Fig. 18. However, in the second variation on the third embodiment, one transparent electrode 324 is wired for each row, as in the first embodiment.

In this manner, according to the second variation on the third embodiment of the present technique, because the control line 333 is connected only to the phase detection pixels, the number of contacts can be reduced compared to a case where the control line 333 is connected to all the pixels.

### <4. Fourth Embodiment>

In the first embodiment described above, in the solid-state image sensor 200, incident light is irradiated on the side (i.e., the surface) on the wiring layer 330-side of the semiconductor substrate 301. However, in this configuration, there is a risk of light being blocked by the wiring of the wiring layer 330. The solid-state image sensor 200 of the fourth embodiment differs from the first embodiment in that the back surface of the semiconductor substrate 301 is irradiated with incident light.

Fig. 25 is an example of a cross-sectional view of the pixel 300 according to the fourth embodiment of the present technique. The pixel 300 of the fourth embodiment differs from the first embodiment in that the photodiode 352 is disposed between the light control element 323 and the wiring layer 330. As a result, light is irradiated on the surface of the semiconductor substrate 301 where the wiring layer 330 is not provided (the back surface). The solid-state image sensor 200 in which light is irradiated on the back surface is called a back surface-illuminated solid-state image sensor. By irradiating light on the back surface, light is no longer blocked by the wiring, and the sensitivity of pixel 300 can be improved compared to a front surface-irradiated type.

The layout of the transparent electrodes 322 and 324 and the light control element 323 according to the fourth embodiment of the present technique is similar to the layout in the first embodiment, illustrated in Fig. 9.

Note that the second embodiment or the third embodiment can also be applied to the fourth embodiment.

In this manner, according to the fourth embodiment of the present technique, because the photodiode 352 is disposed on the back surface of the semiconductor substrate 301, light is no longer blocked by wiring, and the sensitivity of the pixel 300 can be improved as compared to a front surface-illuminated type.

### <5. Fifth Embodiment>

In the first embodiment described above, transparent electrodes are provided, but in this configuration, a polarization filter is required in the optical system when controlling polarization characteristics in the pixel 300. The solid-state image sensor 200 of the fifth embodiment differs from the first embodiment in that opaque electrodes are provided, which makes it possible to control the polarization characteristics.

Fig. 26 is an example of a cross-sectional view of the pixel 300 according to the fifth embodiment of the present technique. The pixel 300 of the fifth embodiment differs from the first embodiment in that metal electrodes are disposed instead of the transparent electrodes 322 and 324. The metal electrode on the ground side has a linear connection part 371 and protruding parts 373, and the metal electrode on the power supply side has a linear connection part 372 and protruding parts 374.

The plan view illustrating the X-Y plane along the O1-O2 axis in this figure is similar to that described in the first embodiment with reference to Fig. 4.

The plan view illustrating the X-Y plane along the A1-A2 axis in this figure is similar to that described in the first embodiment with reference to Fig. 5.

The plan view illustrating the X-Y plane along the B1-B2 axis in this figure is similar to that described in the first embodiment with reference to Fig. 6.

The plan view illustrating the X-Y plane along the C1-C2 axis in this figure is similar to that described in the first embodiment with reference to Fig. 7.

Fig. 27 is a plan view illustrating an example of the arrangement of contacts of the ground line 331 and the control line 333 according to the fifth embodiment of the present technique. The figure illustrates the X-Y plane through an E1-E2 axis indicated in Fig. 26. Contacts between the ground line 331 and the control line 333, and the metal electrode are provided for each pixel.

Fig. 28 is a plan view illustrating an example of the layout of the metal electrodes and the light control element 323 according to the fifth embodiment of the present technique. The figure illustrates the X-Y plane through an H1-H2 axis indicated in Fig. 26.

A plurality of slits are formed in the light control element 323 of the fifth embodiment, as in the second embodiment. Each of the slits is formed along a specific direction perpendicular to the optical axis (the X axis direction or the Y axis direction).

The transparent electrode on the ground side has the linear connection part 371 and a plurality of the protruding parts 373, and the transparent electrode on the power supply side has the linear connection part 372 and a plurality of the protruding parts 374.

The linear connection part 371 is connected to a ground line, and the potential thereof is the ground potential VSS. On the other hand, the linear connection part 372 is connected to a power line, and the control voltage Vctrl is applied thereto. These linear connection parts 371 and 372 extend along a direction (e.g., the X axis direction) perpendicular to the optical axis (the Z axis) and the direction in which the transparent electrodes are arranged (e.g., the Y axis direction).

The protruding parts 373 are connected to the linear connection part 371 on the ground side and protrude along the direction of the slits (the X axis direction or the Y axis direction). On the other hand, the protruding parts 374 are connected to the linear connection part 372 on the power supply side and protrude along the direction of the slits. The protruding parts 373 and 374 are disposed in an alternating manner in respective ones of the plurality of slits.

As illustrated in the figure, by forming a plurality of slits in the light control element 323 and disposing the protruding parts 373 and 374 of the transparent electrodes in those slits, the required control voltage Vctrl can be reduced compared to a case where there are no slits. This makes it possible to reduce the power consumption.

The vertical scanning circuit 210 can also control the polarization characteristics of the pixel 300 by changing the transmittance of the light control element 323. The metal electrodes, including the protruding parts 373 and 374, function as a wire grid-type polarizer. The polarization characteristics thereof vary depending on the transmittance of the light control element 323.

In this manner, according to the fifth embodiment of the present technique, because the light control element 323 has a comb-like shape and opaque metal electrodes are provided, the metal electrodes can function as wire grid-type polarizers. Accordingly, the solid-state image sensor 200 does not need a polarization filter to control the polarization characteristics.

### <6. Sixth Embodiment>

In the fifth embodiment described above, in the solid-state image sensor 200, incident light is irradiated on the side (i.e., the surface) on the wiring layer 330-side of the semiconductor substrate 301. However, in this configuration, there is a risk of light being blocked by the wiring of the wiring layer 330. The solid-state image sensor 200 of the sixth embodiment differs from the fifth embodiment in that the back surface of the semiconductor substrate 301 is irradiated with incident light.

Fig. 29 is an example of a cross-sectional view of the pixel 300 according to the sixth embodiment of the present technique. The pixel 300 of the sixth embodiment differs from the sixth embodiment in that the photodiode 352 is disposed on the back surface of the semiconductor substrate 301 with respect to the front surface. In other words, the photodiode 352 is disposed between the light control element 323 and the wiring layer 330.

Fig. 30 is a plan view illustrating an example of the wiring layout of a ground line 381 and a control line 382 according to the sixth embodiment of the present technique. The figure illustrates the X-Y plane through an F1-F2 axis indicated in Fig. 29. The ground line 381 and the control line 382 are routed between the light control element 323 and the photodiode 352.

Fig. 31 is a plan view illustrating an example of the arrangement of contacts of the ground line 381 and the control line 382 according to the sixth embodiment of the present technique. The figure illustrates the X-Y plane through a G1-G2 axis indicated in Fig. 29. Contacts between respective ones of the ground line 381 and control line 382 and the metal electrodes are provided for each pixel.

The layout of the metal electrodes and the light control element 323 according to the sixth embodiment of the present technique is similar to the layout in the fifth embodiment, illustrated in Fig. 28.

In this manner, according to the sixth embodiment of the present technique, because the photodiode 352 is disposed on the back surface of the semiconductor substrate 301, light is no longer blocked by wiring, and the sensitivity of the pixel 300 can be improved as compared to a front surface-illuminated type. Additionally, because the light control element 323 has a comblike shape and opaque metal electrodes are provided, the metal electrodes can function as wire grid-type polarizers.

### <7. Example of Application in Moving Body>

The technique according to the present disclosure (the present technique) can be applied to various products. For example, the technique according to the present disclosure may be realized as a device mounted on any type of moving body such as an automobile, an electric vehicle, a hybrid electric vehicle, a motorcycle, a bicycle, a personal mobility device, an airplane, a drone, a ship, and a robot.

Fig. 32 is a block diagram illustrating an example of the overall configuration of a vehicle control system, which is an example of a moving body control system to which the technique according to the present disclosure can be applied.

A vehicle control system 12000 includes a plurality of electronic control units connected over a communication network 12001. In the example illustrated in Fig. 32, the vehicle control system 12000 includes a drive system control unit 12010, a body system control unit 12020, an outside-vehicle information detection unit 12030, an in-vehicle information detection unit 12040, and an integrated control unit 12050. Furthermore, as a functional configuration of the integrated control unit 12050, a microcomputer 12051, an audio/image output unit 12052, and an in-vehicle network interface (I/F) 12053 are illustrated.

The drive system control unit 12010 controls the operation of a device related to a vehicle drive system according to various programs. For example, the drive system control unit 12010 functions as a control device for a driving force generating device for generating a driving force of a vehicle such as an internal combustion engine or a drive motor, a driving force transmission mechanism for transmitting a driving force to wheels, a steering mechanism for adjusting a steering angle of a vehicle, and a braking device for generating a braking force of a vehicle.

The body system control unit 12020 controls operations of various devices mounted in a vehicle body according to various programs. For example, the body system control unit 12020 functions as a control device such as a keyless entry system, a smart key system, a power window device, or various lamps such as a headlamp, a back lamp, a brake lamp, a turn signal and a fog lamp. In this case, radio waves transmitted from a portable device that substitutes for a key or signals of various switches may be input to the body system control unit 12020. The body system control unit 12020 receives such a radio wave or signal input, and controls a door lock device, a power window device, and a lamp of the vehicle.

The outside-vehicle information detection unit 12030 detects information outside the vehicle in which the vehicle control system 12000 is mounted. For example, an imaging unit 12031 is connected to the outside-vehicle information detection unit 12030. The outside-vehicle information detection unit 12030 causes the imaging unit 12031 to capture an image of the outside of the vehicle and receives the captured image. The outside-vehicle information detection unit 12030 may perform object detection processing or distance detection processing for people, cars, obstacles, signs, and letters on the road based on the received image.

The imaging unit 12031 is an optical sensor that receives light and outputs an electrical signal according to the intensity of the light received. The imaging unit 12031 can also output the electrical signal as an image and ranging information. In addition, the light received by the imaging unit 12031 may be visible light or invisible light such as infrared rays.

The in-vehicle information detection unit 12040 detects information in the vehicle. In the in-vehicle information detection unit 12040, for example, a driver status detection unit 12041 that detects the driver's status is connected. The driver status detection unit 12041 includes, for example, a camera that images the driver, and the in-vehicle information detection unit 12040 may calculate the degree of fatigue or degree of concentration of the driver based on detection information input from the driver status detection unit 12041, and may determine whether the driver is asleep.

The microcomputer 12051 can calculate a control target value of the driving force generator, the steering mechanism, or the braking device on the basis of the information on inside and outside the vehicle acquired by the outside-vehicle information detection unit 12030 or the in-vehicle information detection unit 12040, and output a control command to the drive system control unit 12010. For example, the microcomputer 12051 can perform cooperative control for the purpose of implementing functions of an advanced driver assistance system (ADAS) including collision avoidance or impact mitigation of the vehicle, follow-up traveling based on an inter-vehicle distance, vehicle speed maintenance traveling, vehicle collision warning, vehicle lane departure warning, or the like.

In addition, the microcomputer 12051 can perform cooperative control for automatic driving in which autonomous driving is performed without the operation of the driver by controlling the driving force generating device, the steering mechanism or the braking device based on information around the vehicle acquired by the outside-vehicle information detection unit 12030 or the in-vehicle information detection unit 12040.

In addition, the microcomputer 12051 can output a control command to the body system control unit 12020 based on the information outside the vehicle acquired by the outside-vehicle information detection unit 12030. For example, the microcomputer 12051 can perform cooperative control for antiglare such as switching a high beam to a low beam by controlling a headlamp according to a position of a preceding vehicle or an oncoming vehicle detected by the outside-vehicle information detection unit 12030.

The audio/image output unit 12052 transmits an output signal of at least one of audio and an image to an output device that can visually or audibly notify an occupant of the vehicle or the outside of information. In the example illustrated in Fig. 32, as such an output device, an audio speaker 12061, a display unit 12062 and an instrument panel 12063 are shown. The display unit 12062 may include, for example, at least one of an onboard display and a heads-up display.

Fig. 33 is a diagram illustrating an example of an installation position of the imaging unit 12031.

In Fig. 33, imaging units 12101, 12102, 12103, 12104, and 12105 are provided as the imaging unit 12031.

The imaging units 12101, 12102, 12103, 12104, and 12105 may be provided at positions such as a front nose, side-view mirrors, a rear bumper, a back door, and an upper part of a windshield in a vehicle interior of the vehicle 12100, for example. The imaging unit 12101 provided at the front nose and the imaging unit 12105 provided at an upper part of the windshield in the vehicle interior mainly obtains front view images of the vehicle 12100. The imaging units 12102 and 12103 provided in the side-view mirrors mainly obtain side view images of the vehicle 12100. The imaging unit 12104 provided in the rear bumper or the back door mainly obtains a rear view image of the vehicle 12100. The front images acquired by the imaging unit 12105 is mainly used for detecting a preceding vehicle, a pedestrian, an obstacle, a traffic light, a traffic sign, a lane, or the like.

Here, Fig. 33 illustrates an example of imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side mirrors, and an imaging range 12114 indicates the imaging range of the imaging unit 12104 provided at the rear bumper or the back door. For example, a bird's-eye view image of the vehicle 12100 as viewed from above can be obtained by superimposition of image data captured by the imaging units 12101 to 12104.

At least one of the imaging units 12101 to 12104 may have a function of acquiring distance information. For example, at least one of the imaging units 12101 to 12104 may be a stereo camera including a plurality of image sensors or an image sensor having pixels for phase difference detection.

For example, the microcomputer 12051 determines a distance to each three-dimensional object in the imaging ranges 12111 to 12114, and a change in the distance over time (a relative speed with respect to the vehicle 12100) based on the distance information obtained from the imaging units 12101 to 12104, and particularly, can extract a three-dimensional object that travels at a predetermined speed (for example, 0 km/h or more) in almost the same direction as the vehicle 12100, which is the closest three-dimensional object on the traveling path of the vehicle 12100, as a preceding vehicle. In addition, the microcomputer 12051 can set an inter-vehicle distance to be secured in advance in front of the preceding vehicle, and perform automatic brake control (including following stop control), automatic acceleration control (including following start control), and the like. In this manner, it is possible to perform cooperative control for automatic driving in which autonomous driving is performed without the operation of the driver.

For example, based on the distance information obtained from the imaging units 12101 to 12104, the microcomputer 12051 classifies the three-dimensional object data related to the three-dimensional object as a two-wheeled vehicle, an ordinary vehicle, a large vehicle, a pedestrian, a utility pole or another three-dimensional object and performs extraction, and can us the result for automatic avoidance of an obstacle. For example, the microcomputer 12051 distinguishes obstacles around the vehicle 12100 as obstacles that the driver of the vehicle 12100 can visually recognize and obstacles that are difficult for the driver to visually recognize. Therefore, the microcomputer 12051 determines collision risk indicating the degree of risk of collision with each obstacle, and when the collision risk is equal to or higher than the set value and there is a possibility of collision, an alarm is output to the driver through the audio speaker 12061 and the display unit 12062, forced deceleration and avoidance steering are performed through the drive system control unit 12010, and thus it is possible to perform driving support for collision avoidance.

At least one of the imaging units 12101 to 12104 may be an infrared camera that detects infrared rays. For example, the microcomputer 12051 can recognize a pedestrian by determining whether there is a pedestrian in the captured image of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating the outline of the object and it is determined whether the object is a pedestrian. When the microcomputer 12051 determines that there is a pedestrian in the captured images of the imaging units 12101 to 12104, and the pedestrian is recognized, the audio/image output unit 12052 controls the display unit 12062 so that the recognized pedestrian is superimposed and displayed with a square contour line for emphasis. In addition, the audio/image output unit 12052 may control the display unit 12062 so that an icon or the like indicating a pedestrian is displayed at a desired position.

An example of the vehicle control system to which the technology according to the present disclosure can be applied has been described above. The technique according to the present disclosure may be applied to the imaging unit 12031 and the like among the configurations described above. Specifically, the imaging device 100 in Fig. 1 can be applied to the imaging unit 12031. By applying the technique according to the present disclosure to the imaging unit 12031, the oblique incidence characteristics can be improved and a clearer captured image can be obtained, which makes it possible to reduce driver fatigue.

Meanwhile, the above-described embodiments show examples for embodying the present technique, and matters in the embodiments and matters specifying the invention in the claims have a corresponding relationship with each other. Similarly, the matters specifying the invention in the claims and the matters in the embodiments of the present technique having the same name have a corresponding relationship with each other. However, the present technique is not limited to the embodiments and can be embodied by applying various modifications to the embodiments without departing from the gist thereof.

In addition, the effects described in the present specification are merely examples and are not intended as limiting, and other effects may be obtained.

The present technique can also have the following configurations.
(1) A solid-state image sensor, comprising:
   a pair of electrodes disposed along a predetermined arrangement direction perpendicular to an optical axis of incident light; and
   a light control element that is disposed between the pair of electrodes and that transmits the incident light at a transmittance based on a voltage between the pair of electrodes.
(2) The solid-state image sensor according to the foregoing (1), wherein the light control element is an element having a plate shape.
(3) The solid-state image sensor according to the foregoing (2),
   wherein the pair of electrodes and the light control element are provided for each of a plurality of pixels, and
   the light control element is disposed in a region covering part of a light-receiving region of a photodiode.
(4) The solid-state image sensor according to the foregoing (2),
   wherein the pair of electrodes and the light control element are provided for a specific pixel among a plurality of pixels, and
   the light control element is disposed in a region covering part of a light-receiving region of a photodiode.
(5) The solid-state image sensor according to the foregoing (2), further comprising:
   a control line; and
   a ground line,
   wherein the pair of electrodes and the light control element are provided for each of a plurality of pixels, and
   the pair of electrodes provided for a specific pixel among the plurality of pixels are connected to the control line and the ground line.
(6) The solid-state image sensor according to the foregoing (1),
   wherein a plurality of slits extending in a specific direction are formed in the light control element,
   each of the pair of electrodes includes:
      a linear connection part extending in a direction perpendicular to the arrangement direction and the optical axis; and
      a protruding part protruding along the specific direction, and
      the protruding part is disposed in a corresponding one of the slits.
(7) The solid-state image sensor according to any one of the foregoing (1) to (6), wherein the pair of electrodes are transparent.
(8) The solid-state image sensor according to any one of the foregoing (1) to (6), wherein the pair of electrodes are opaque.
(9) The solid-state image sensor according to any one of the foregoing (1) to (8), further comprising:
   a wiring layer; and
   a photoelectric conversion element that receives the incident light,
   wherein the wiring layer is disposed between the light control element and the photoelectric conversion element.
(10) The solid-state image sensor according to any one of the foregoing (1) to (8), further comprising:
   a wiring layer; and
   a photoelectric conversion element that receives the incident light,
   wherein the photoelectric conversion element is disposed between the light control element and the wiring layer.
(11) An imaging device, comprising:
   a pair of electrodes disposed along a predetermined arrangement direction perpendicular to an optical axis of incident light;
   a light control element that is disposed between the pair of electrodes and that transmits the incident light at a transmittance based on a voltage between the pair of electrodes; and
   a signal processing circuit that processes a pixel signal according to an intensity of the incident light.

### [Reference Signs List]

100 Imaging device
110 Optical unit
120 DSP circuit
130 Display unit
140 Operating unit
150 Bus
160 Frame memory
170 Storage unit
180 Power supply unit
200 Solid-state image sensor
210 Vertical scanning circuit
220 DAC
230 Timing control circuit
240 Pixel array unit
250 Column signal processing circuit
260 Horizontal scanning circuit
300 Pixel
301 Semiconductor substrate
311 On-chip lens
312 Color filter
321 Oxide film
322, 324 Transparent electrode
323 Light control element
330 Wiring layer
331, 381 Ground line
332 Power line
333, 382 Control line
334 Transfer line
335 Selection line
336 FD line
337 Vertical signal line
338 Reset line
341 Transfer transistor
342 Reset transistor
343 Amplifying transistor
344 Selection transistor
351 Element separation region
352 Photodiode
353 Floating diffusion layer
361, 362, 371, 372 Linear connection part
363, 364, 373, 374 Protruding part
12031 Imaging unit

## Claims

1. A solid-state image sensor, comprising:
a pair of electrodes disposed along a predetermined arrangement direction perpendicular to an optical axis of incident light; and
a light control element that is disposed between the pair of electrodes and that transmits the incident light at a transmittance based on a voltage between the pair of electrodes.

2. The solid-state image sensor according to claim 1,
wherein the light control element is an element having a plate shape.

3. The solid-state image sensor according to claim 2,
wherein the pair of electrodes and the light control element are provided for each of a plurality of pixels, and
the light control element is disposed in a region covering part of a light-receiving region of a photodiode.

4. The solid-state image sensor according to claim 2,
wherein the pair of electrodes and the light control element are provided for a specific pixel among a plurality of pixels, and
the light control element is disposed in a region covering part of a light-receiving region of a photodiode.

5. The solid-state image sensor according to claim 2, further comprising:
a control line; and
a ground line,
wherein the pair of electrodes and the light control element are provided for each of a plurality of pixels, and
the pair of electrodes provided for a specific pixel among the plurality of pixels are connected to the control line and the ground line.

6. The solid-state image sensor according to claim 1,
wherein a plurality of slits extending in a specific direction are formed in the light control element,
each of the pair of electrodes includes:
a linear connection part extending in a direction perpendicular to the arrangement direction and the optical axis; and
a protruding part protruding along the specific direction, and
the protruding part is disposed in a corresponding one of the slits.

7. The solid-state image sensor according to claim 1,
wherein the pair of electrodes are transparent.

8. The solid-state image sensor according to claim 1,
wherein the pair of electrodes are opaque.

9. The solid-state image sensor according to claim 1, further comprising:
a wiring layer; and
a photoelectric conversion element that receives the incident light,
wherein the wiring layer is disposed between the light control element and the photoelectric conversion element.

10. The solid-state image sensor according to claim 1, further comprising:
a wiring layer; and
a photoelectric conversion element that receives the incident light,
wherein the photoelectric conversion element is disposed between the light control element and the wiring layer.

11. An imaging device, comprising:
a pair of electrodes disposed along a predetermined arrangement direction perpendicular to an optical axis of incident light;
a light control element that is disposed between the pair of electrodes and that transmits the incident light at a transmittance based on a voltage between the pair of electrodes; and
a signal processing circuit that processes a pixel signal according to an intensity of the incident light.
